# EUROPEAN PATENT SPECIFICATION

(11) **EP 0 470 802 B1**
(45) Date of publication and mention of the grant of the patent: **18.06.1997**
(21) Application number: 91307192.4
(22) Date of filing: 05.08.1991
(51) Int. Cl.: G06F 11/26, G06F 11/22

(54) **Event qualified test methods and circuitry**
Durch Ereignis befähigte Prüfverfahren und Schaltungen
Procédés de test et circuits qualifiés par l'événement

(30) Priority: 06.08.1990 US 563573
(43) Date of publication of application: 12.02.1992
(73) Proprietor: TEXAS INSTRUMENTS INCORPORATED, Dallas Texas 75265 (US)
(72) Inventor: Whetsel, Lee D., Jr., Plano, Texas 75025 (US)
(74) Representative: Nettleton, John Victor

(56) References cited:
- EP-A- 0 315 475
- EP-A- 0 382 360
- US-A- 4 811 299

## Description

### RELATED APPLICATIONS

This application is related to U. S. Patent US-A-5 001 713 entitled "Event Qualified Testing Architecture for Integrated Circuits", corresponding to EP-A-0 382 360, U. S. Patent Application No. 374,896, filed June 30, 1989, entitled "Digital Bus Monitor Integrated Circuits", U. S. Patent No. 5,056,093 entitled "System Scan Path Architecture", and U. S. Patent No. 5,054,024 entitled "System Scan Path Protocols".

### TECHNICAL FIELD OF THE DISCLOSURE

This invention relates in general to electronic circuits, and more particularly to an event qualified test architecture.

### BACKGROUND OF THE DISCLOSURE

As semiconductor technologies continue to increase the speed at which ICs operate, at-speed functional testing at both the IC and circuit board level becomes more difficult. Traditionally, circuit boards are tested at-speed using functional test equipment. Functional testers input test patterns to a board's primary inputs and measure the response from the board's primary outputs. If the primary outputs do not match the expected response the functional test fails. The cost to purchase or design high speed functional testers capable of keeping up with state-of-the-art board design is rapidly escalating.

With the recent announcement of the IEEE 1149.1 boundary scan standard, more ICs designs will include boundary scan as a method to improve board level testability. The 1149.1 standard describes a test architecture that can be designed into ICs to facilitate testing of wiring interconnects between ICs in a circuit.

The 1149.1 architecture comprises a test access port (TAP) and a series of scannable boundary test cells, one cell per input and output signal. The input test cells are combined into an input test cell register (TCR1) and the output test cells are combined into an output test cell register (TCR2).

The 1149.1 standard provides an instruction, referred to as external test (Extest) which places the IC in an off-line non-functional test mode and allows the IC's output pins to be controlled by TCR2, while the input pins are observable via TCR1. This instruction allows the wiring interconnects as well as combinational logic between ICs on a board design to be easily tested by repetitive scan access operation to TCR1 and TCR2.

In addition, the 1149.1 standard provides an instruction, referred to as Sample, which allows the ICs boundary scan path to be accessed while the IC is in an on-line functional mode. In response to control input to the TAP, the Sample instruction captures the data entering and leaving the IC in TCR1 and TCR2 then shifts it out for inspection. This test does not affect the operation of the IC.

The Sample instruction, however, has several limitations. One problem involves synchronizing the control inputs so that data can be sampled while in a stable state, not in a transitioning state. Another problem with the Sample instruction involves qualifying when the boundary data is to be sampled. In order to obtain meaningful data the sample operation should be qualified by the occurrence of an expected event. Sampling data synchronously, but at random has limited practical applications in system testing.

Still another problem with the Sample instruction is that the same control signals are routed globally to each IC on a board design to allow shifting data through all ICs during scan operations. Since each IC receives the same control signals the data sample operation must be applied globally across all IC boundaries. In typical board designs not all ICs operate on the same system clock, therefore it is impossible to obtain valid data from all IC boundaries with one sample operation.

Therefore, a need has arisen for a circuit design which will allow the board level functional testing to be performed by test logic in the IC's themselves, rather than by external test equipment. Further, the test circuitry should sample data in a stable state, respond to qualifying events, and should operate with separate system clocks.

EP-A-0 315 475 discloses an event qualification structure providing the timing and control required to activate an integrated circuit's test logic during normal functional operation. A logic circuit has an input and an output for signal data. Selected ones of the logic circuit's input and output have a test cell coupled thereto, each test cell having at least one storage means for storing a test condition. Each test cell also has a comparator for comparing the signal data with the stored condition. Each comparator generates control signals indicating a true comparison between the signal data and the stored condition. A combining circuit is provided for combining the control signals and generating a second control signal used to indicate that a pre-selected pattern of inputs and outputs has occurred.

A local controller is used to control built-in test logic in a logic core. The arrangement has the ability to test and/or terminate a test in response to a condition.

EP-A-0 382 360, a document falling with the terms of Article 54(3) EPC, discloses boundary test architecture which may be used in an integrated circuit to perform boundary testing while the integrated circuit is in the functioning mode. Input circuitry is provided for receiving incoming data and output circuitry is provided to output data from the integrated circuit. Logic circuitry is connected between the input and output circuitry for performing a desired function, such as storage or logical operations, on the incoming data. Test circuitry is connected to the input and output circuitry for analyzing and storing data in response to detection of the predetermined condition. The predetermined condition may be detected by comparing data from the logic circuitry with an expected data word stored in a register or memory. Some bits of the expected data word may be masked using a masking data word such that the mask bits are not involved in the matching operation.

In a second example, a second predetermined condition may be detected, at which time the storage and analysis will cease. The storage and analysis may be resumed after detection of a third predetermined condition and stop after the detection of a fourth predetermined condition.

In a third example, the testing architecture includes circuitry to output test data through the output circuitry in response to a predetermined condition. The output of test data may be stopped on detection of a second predetermined condition and resumed on the detection of a third predetermined condition. After a fourth predetermined condition, the output may be stopped.

In a fourth example, a buffer memory is used in the test circuit to store a plurality of input data words into the integrated circuit and test data words for output from the integrated circuit.

The present invention provides a method of testing a circuit comprising the steps of:
providing at least one event qualification cell having an internal memory and having compare circuitry for comparing data input into the compare circuitry with data stored in said internal memory;
operating said event qualification cell for detecting each occurrence of a specified event;
counting the number of occurrences of the specified event;
executing a test responsive to detecting a predetermined number of occurrences of the specified event; and
executing said test for a predetermined number of clock cycles.

The invention also provides circuitry for testing a circuit comprising:
at least one event qualification cell having an internal memory and having compare circuitry for comparing data input into the compare circuitry with data stored in said internal memory, operable for detecting each occurrence of a specified event;
circuitry for counting the number of occurrences of the specified event;
circuitry for executing a test responsive to detecting a predetermined number of occurrences of the specified event; and
circuitry for causing said test to be executed for a predetermined number of clock cycles.

The present invention provides several technical advantages over the prior art. The present invention overcomes the problems described in 1149.1 Sample instruction and provides methods to perform test functions beyond sampling single data patterns. A test may be started and stopped responsive to a predetermined occurrence of an event. The beginning or end of a test may be delayed from the predetermined occurrence by a predetermined number of clock cycles. The test is executed for a predetermined number of cycles. When the present invention is enabled to control a test operation, it operates independently from the circuits TAP, allowing different circuits to operate different tests at different times. Having local test controlling circuit, instead of global test control input to all circuits, decentralizes testing at the circuit board level.

Further, the present invention ability to enable boundary test logic while the host circuit is operating normally, allows testing the at-speed data transfers between circuits. The present invention provides the ability to test for at-speed related problems when physical probing of the board design is not possible or when probing affects the operation of the board.

### BRIEF DESCRIPTION OF THE DRAWINGS

For a more complete understanding of the present invention, and the advantages thereof, reference is now made to the following descriptions taken in conjunction with the accompanying drawings, in which:
FIGURE 1 illustrates an integrated circuit implementing the IEEE 1149.1 boundary scan architecture;
FIGURE 2 illustrates a block diagram of the test architecture of the present invention;
FIGURE 3 illustrates a block diagram of an event qualification cell;
FIGURE 4 illustrates a block diagram of an alternative embodiment of an event qualification cell;
FIGURE 5 illustrates a block diagram of an event qualification module;
FIGURE 6 illustrates a block diagram of the event qualification module controller;
FIGURE 7 illustrates a flow chart depicting how the state machine of the event qualification module controller selects test protocols;
FIGUREs 8-17 illustrate state diagrams of test protocols;
FIGURE 18 illustrates a block diagram of a circuit board including a plurality of sub-circuits having the test architecture of the present invention;
FIGURE 19 illustrates a block diagram of a digital signal monitor using the present invention; and
FIGURE 20 illustrates a block diagram of an analog signal monitor using the present invention.

### DETAILED DESCRIPTION OF THE DISCLOSURE

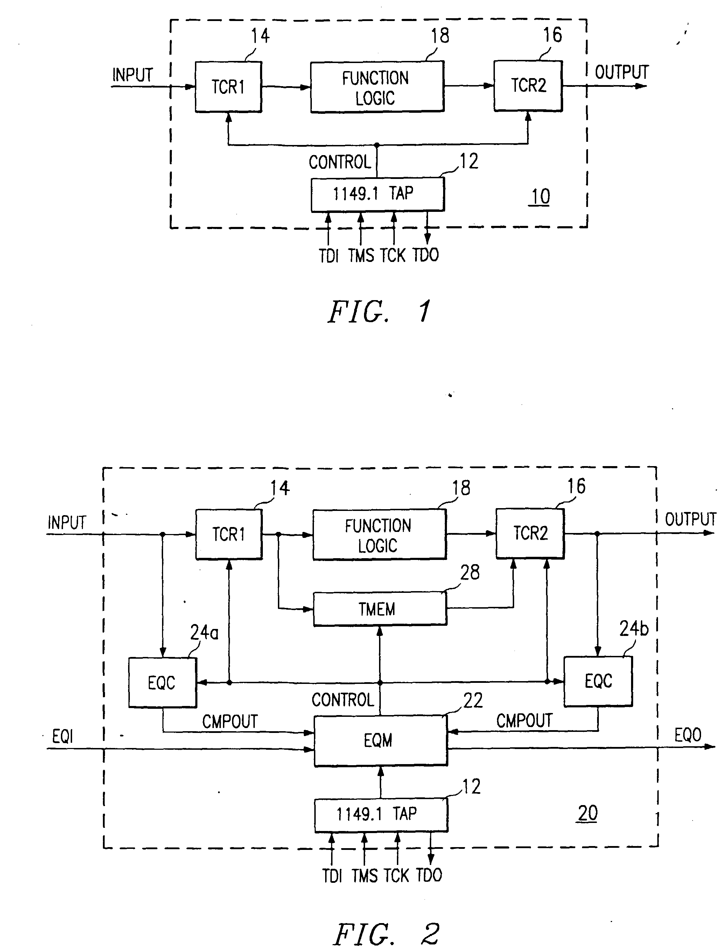

The preferred embodiment of the present invention is best understood by referring to FIGUREs 1-20 of the drawings, like numerals being used for like and corresponding parts of the various drawings.

FIGURE 1 illustrates an integrated circuit (IC) implementing the IEEE 1149.1 boundary scan architecture. The IC 10 comprises a test access port (TAP) and a series of scannable boundary test cells, one cell per input and output signal. The input test cells are combined into an input test cell register (TCR1) 14 and the output test cells are combined into an output test cell register (TCR2) 16. The function logic 18 of the IC 10 is coupled between TCR1 and TCR2.

The TAP 12 provides a serial interface into the test logic of the IC 10. The TAP 12 receives two control inputs, a test clock (TCK) and a test mode select (TMS), that regulate its operation. Also, the TAP 12 has a test data input (TDI) and a test data output (TDO) to allow serial data to be input to and output from the test architecture. Internal to the TAP 12 is an instruction register which can be serially accessed, via the TDI and TDO pins, to load test commands.

The Extest instruction places the IC 10 in an off-line, non-functional test mode and allows the IC's output pins to be controlled by TCR2, which the input pins are observable via TCR1 14. During this instruction, the TAP 12 receives external control from TMS and TCK to control the input and output pins of the IC 10 via TCR1 and TCR2. During the Extest instruction, the IC's output pins can be made to drive out test data while the input pins receive test data. This instruction allows the wiring interconnects between ICs on a board, as well as the function logic 18, to be easily tested by repetitive scan access operation to TCR1 14 and TCR2 16.

Additionally, the sample instruction allows the boundary scan path of the IC 10 to be access while the IC 10 is in an on-line functional mode. In response to a control input to the TAP 12, the sample instruction captures data entering and leaving the IC in TCR1 14 and TCR2 16, then shifts the captured data out for inspection. The sample test does not affect the operation of the integrated circuit 10.

In operation, however, the Sample instruction has several problems that limit its use. One problem involves synchronizing the TCK and TMS control inputs to the system data traversing the boundary of the target IC, such that the data is sampled while in a stable state, not in a transitioning state. Another problem with the Sample instruction involves qualifying the times at which the boundary data is sampled. In order to obtain meaningful data, the Sample operation should be qualified by the occurrence of an expected event. Sampling data synchronously, but at random has limited practical applications in system testing.

Yet another problem with the Sample instruction is that the TCK and TMS control signals are routed globally to each IC on a board design in order to shift data through all ICs during scan operations. Since each IC receives the same control signals, the data Sample operation must be applied globally across all IC boundaries. In a typically board design, several system clocks are used to the various ICs; therefore, it is impossible to obtain valid data from all IC boundaries with one Sample operation. Hence, in order to use the Sample instruction, the instruction is repeated with different control signals selected. Therefore, one TCK and TMS pair may be selected to operate Sample operation on one IC in the circuit, followed by selecting another TCK and TMS pair to repeat the Sample operation on another IC in the circuit.

The present invention performs at-speed system testing of a circuit comprising multiple ICs. While this disclosure describes the invention in the context of multiple ICs mounted on a board, the circuit could be used with multiple subcircuits in an IC design, multiple ICs mounted on a common substrate (wafer scale integration), or multiple circuit boards installed in a system.

FIGURE 2 illustrates a block diagram of the present invention. An IC 20 incorporating the present invention comprises a TAP 12, TCR1 14, TCR2 16 and function logic 18, as described in connection with FIGURE 1. The TAP 12 is connected to an event qualification module (EQM) 22. The EQM 22 receives an event qualification input (EQI) signal and outputs an event qualification output (EQO) signal. The EQM 22 also outputs control signals to event qualification cells 24 a-b (denoted generally by reference numeral 24), TCR1 14, TCR2 16 and a test memory (TMEM) 28. The EQM receives outputs from the EQCs 24a-b. The EQCs 24a-b receive inputs from the input signal (also connected to TCR1) and from the output of the TCR2 16, respectively. The output of TCR1 is connected to the input of the TMEM 28 and the output of the TMEM 28 is connected to the input of TCR2 16. The TAP, TCRs, EQM and TMEM are further described in connection with U. S. Patent US-A-5 001 713, entitled "Event Qualified Testing Architecture for Integrated Circuits", U. S. Patent Application No. 374,896, filed June 30, 1989, entitled "Digital Bus Monitor Integrated Circuits", U. S. Patent US-A-5 056 093, entitled "System Scan Path Architecture", and U. S. Patent US-A-5 054 024, entitled "System Scan Path Protocols", to Whetsel.

When attempting to use boundary test logic to perform at-speed functional testing, a method of qualifying when to issue control to enable the test logic is necessary. The event qualification architecture of the present invention provides such a method by placing the qualification and control logic, required for enabling test logic, within the IC design itself, thus eliminating the need for external test control. When qualified, the architecture takes control of the host IC's boundary (or other) test logic and causes it to operate synchronous with the IC during test.

An event qualification cell (EQC) is coupled with each IC input and output signal that can serve, either by itself or in combination with other signals, as a test qualifier. In addition, a local controller referred to as an event qualification module (EQM) 22 is included in the IC 20 to provide the local qualification and control for the IC's test logic.

The EQCs 24a-b and EQM 22 are both selectable by the TAP 12 to allow serial access to the architecture. The architecture does not inhibit any of the IEEE 1149.1 test operations. The architecture provides an embedded capability allowing TCR1 14 and TCR2 16 to be synchronously enabled with the IC's I/O data at a qualified time, to effectuate on-line testing at the ICs boundary.

The TCRs 14 and 16 can be set up to operate as either observability or controllability logic. When the TCRs are in an observability mode, they can be further setup to either take a snap-shot sample of a single data pattern entering and/or leaving the IC 20, or to allow multiple data patterns to be compressed into a signature, using signature analysis techniques. The data sample observation mode allows testing a single input and/or output data pattern, whereas the signature analysis observation mode allows testing for a correct sequence of multiple input and/or output data patterns. If the signature matches an expected signature, the data patterns sequence is correct, otherwise one or more of the data patterns in the sequence had an error.

When the TCRs 14 and 16 are in a controllability mode, they can be setup to insert either a single test data pattern or a generated sequence of pseudo-random or counting patterns in place of the normal system data entering and/or leaving the IC. In some test situations, one TCR may be setup to perform a control function, while the other TCR performs an observation function.

In addition to the TCR1 14 and TCR2 16 test logic blocks, the IC 20 contains a test memory (TMEM) 28 which can be setup to store input data entering the IC and/or insert stored test data in place of system data normally output from the IC. The advantage the memory has over the TCRs is the ability to store and/or output multiple test data patterns. The memory, like the TCRs 14 and 16, can be serially accessed via the TAP 12 to load or unload test data.

During on-line system testing the TCRs 14 and 16 and TMEM 28 receive control from the EQM 22, not the TAP 12, to operate the observability and/or controllability test functions setup in each. Using the TCRs 14 and 16 and TMEM 28, it is possible to setup the test architecture to perform any of the tests described above either individually or in any combination. A list of the test operations and their combinations are shown in Table 1.

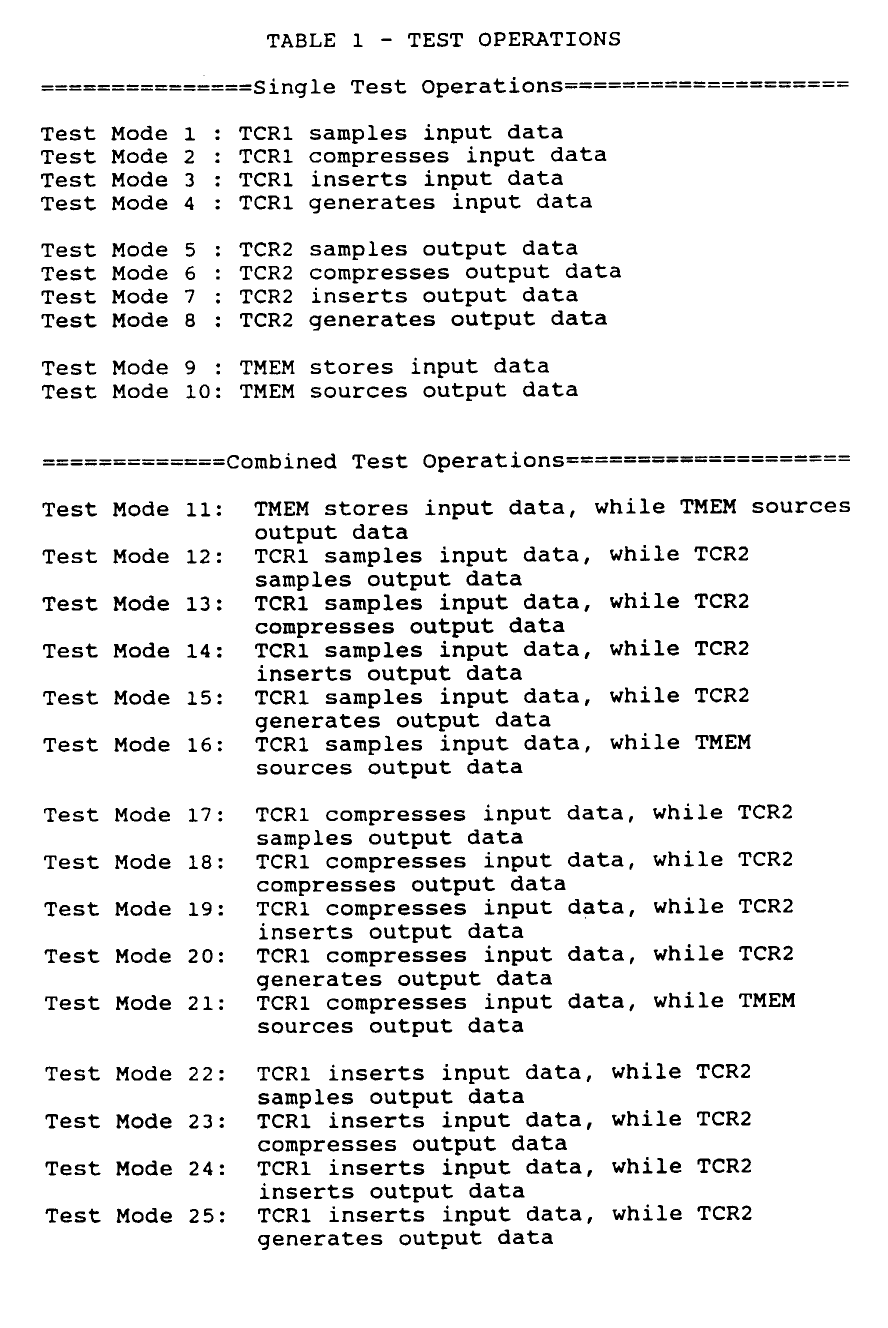

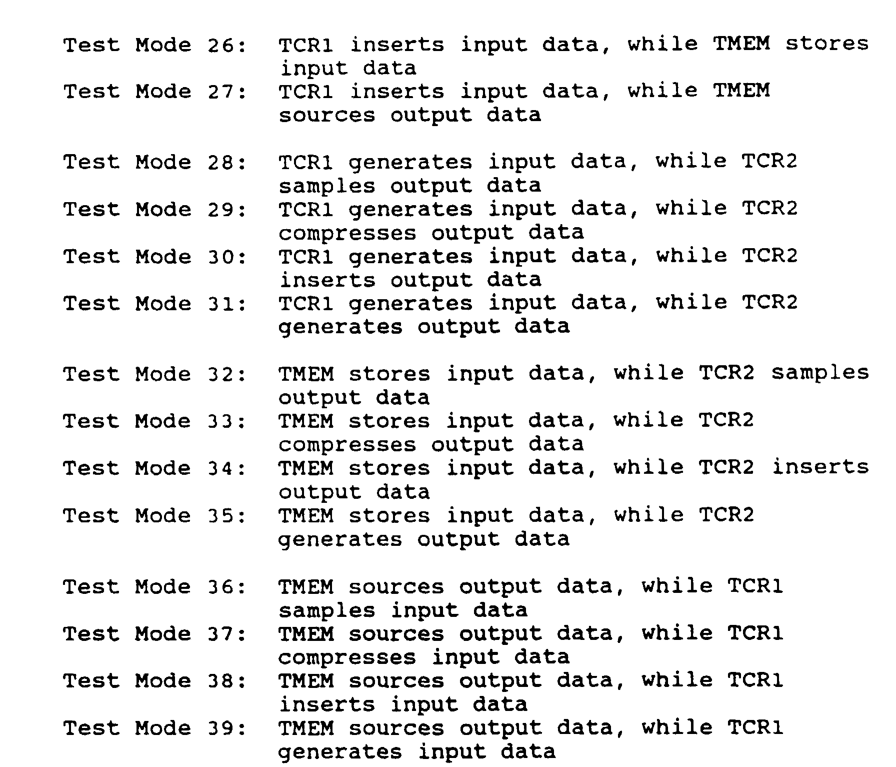

### Event Qualification Cells (EQCs)

The basic task of the EQCs 24a-b is comparing a received signal against a stored signal, and outputting a signal to indicate when the two signals match. While the application of EQCs 24a-b in this disclosure describes their use at the input and output boundaries of an IC design, it must be understood that they can be used at the boundary of any well defined logic block that has inputs and/or outputs for signal data.

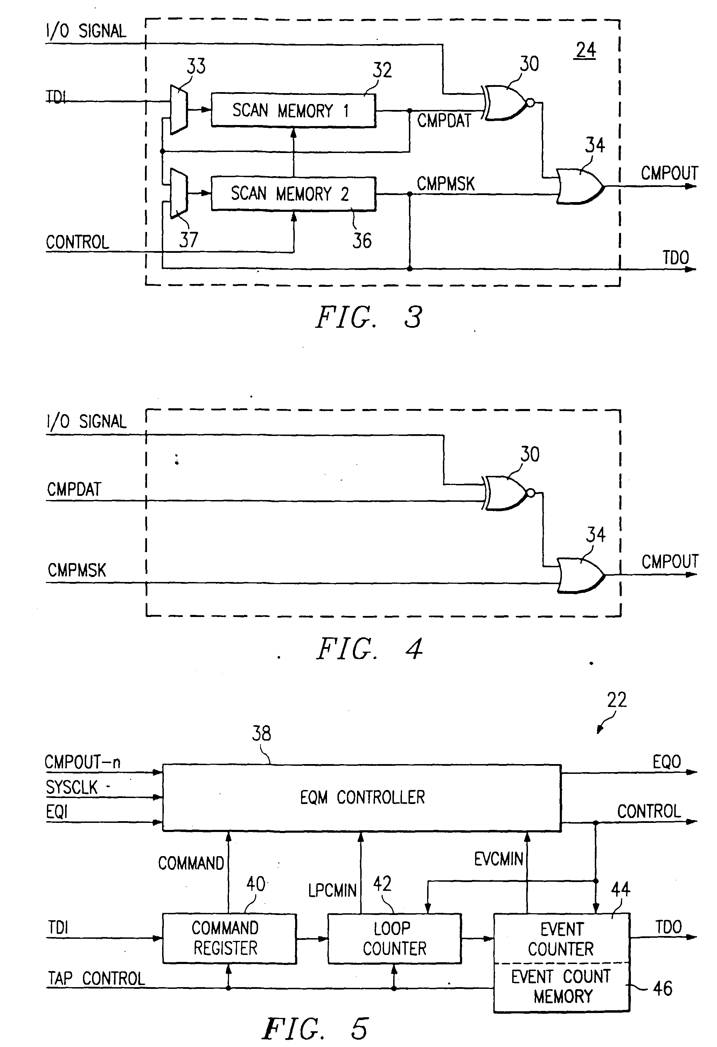

FIGURE 3 illustrates a block diagram of an EQC 24. An I/O signal, such as that supplied by the INPUT signal to EQC 24a or the output of TCR2 16 to EQC 24b, is coupled to one input of an exclusive NOR gate 30. The other input to the XNOR gate 30 is received from the output of a scan memory cell 32. The input of the scan memory cell 32 is coupled to a multiplexer 33 and control is input from the EQM 22. The multiplexer 33 inputs the TDI signal and the output of the scan memory 32. The output of the XNOR gate 30 is connected to the input of a OR gate 34; the other input to the OR gate 34 is supplied by the output of a second scan memory cell 36. The input of the scan memory cell 36 is connected to a multiplexer 37 and control is input from the EQM 22. Multiplexer 37 inputs the output of scan memory 32 and the output of scan memory 36. The output of the scan memory cell 36 is coupled to the TDO output signal. The output of the OR gate 34 comprises the CMPOUT signal, which is connected to the EQM 22.

The EQC 24a in Figure 3 contains compare circuitry (XNOR gate 30) and scannable memories 32 and 36 for storing a plurality of compare data (CMPDAT) and compare mask (CMPMSK) bits. The EQCs 24 have inputs for receiving the boundary I/O signal to be compared and for receiving control from the EQM 22. The EQCs 24 have a compare output (CMPOUT) to transmit the result of the compare operation to the EQM 22. When a match occurs between the I/O signal and the CMPDAT bit being output from memory 32, the CMPOUT output transmits a match signal to the EQM 22 to indicate the occurrence of the match. The EQC's compare circuitry can be disabled by the CMPMSK bit output from memory 36, so that the EQC outputs a match signal on CMPOUT regardless of whether a match occurred between the I/O signal and CMPDAT bit. The memories output the CMPDAT and CMPMSK bits to the compare logic simultaneously, allowing three possible operations: compare I/O signal against a logic one, compare I/O signal against a logic zero, or mask compare operation and force a true compare output. Compare masking allows assigning "don't care" conditions to one or more I/O signals that are not required in the qualification of a particular test operation.

The memories 32 and 36 are typically simple shift registers of equal length. When accessed by the TAP 12 (via the EQM), the memories are linked together via Mux 37 to allow shifting data into and out of the memories via the TDI and TDO pins. During scan access all the EQCs in the IC are linked together to form a serial shift register. The EQC shift register is coupled to the IC's TDI input and TDO output pins during the scan operation to allow data to be input to and output from the EQC shift register. When they are not being accessed by the TAP 12 for shift operations, the memories can be controlled by the EQM 22 to output CMPDAT and CMPMSK data bits to the compare circuit during the execution of one of the EQM's protocols.

In operation, the TAP 12 loads the memories with CMPDAT and CMPMSK data bits to be used in an EQM protocol. After the memories are loaded the TAP 12 accesses the EQM 22 to load a protocol command and enable the EQM 22 to control the memories. The serial output of each memory 32 and 36, following the shift operation, is the first CMPDAT and CMPMSK data bits used in the EQM's first compare operation. After the first compare operation completes, the EQM issues control to the memories 32 and 36 to shift out a second pair of CMPDAT and CMPMSK data bits that are to be used on a second compare operation. When the memories 32 and 36 output the next pair of CMPDAT and CMPMSK bits, the previous bit pair is fed back into the respective memories via Mux 33 and 37 and stored into the memories. By circulating the bit pairs back through the memories, a compare output sequence can be repeated an infinite number of times.

While the EQM 22 has protocols that operate on a single CMPDAT and CMPMSK bit storage, other protocols require storage of multiple CMPDAT and CMPMSK data bits. The CMPDAT and CMPMSK memories should be able to store at least two bits each, to allow outputting two pairs of CMPDAT and CMPMSK data bits. Two pairs of CMPDAT and CMPMSK bits allow the EQM to start a test operation in response to a condition detected with the first pair, then stop the test operation in response to a condition detected with the second pair. Some of the test protocols executed by the EQM 22 may require additional storage of CMPDAT and CMPMSK data bits to allow multiple start/stop and/or other compare operations required for testing.

To allow more efficient storage of CMPDAT and CMPMSK data, a single remote memory may be used instead of having local memories inside each EQC. The EQC of Figure 5 illustrates the cell design without the local memories 32 and 36. The function of the EQC 24 is the same, the only difference is that the CMPDAT and CMPMSK bit signals are stored in a remote memory instead of in the cell itself.

### Event Qualification Module (EQM)

FIGURE 5 illustrates a block diagram of an EQM comprising a finite state machine controller 38 and a scan path comprising command register 40, loop counter 42, and event counter 44. The controller has inputs for receiving the CMPOUT signals (CMPOUT 1-n) from the EQCs 24, a system clock (SYSCLK), an external event qualification input (EQI) signal, a command from the command register 40, a loop count minimum (LPCMIN) signal from the loop counter 42, and a event count minimum (EVCMIN) signal from the event counter 44 coupled to an event count memory 46. The controller 39 has outputs for controlling test logic and EQCs and for outputting an external event qualification output (EQO) signal. While not shown in Figure 1, the controller also receives a system clock from either the IC's function logic or from an external system clock input. The system clock driving the EQM's controller is synchronous with the I/O boundary data. Synchronizing the controller with the system clock allows it, as well as the test logic it controls, to operate synchronous to the system logic being tested. The EQM's scan path receives scan control input (TAP CONTROL) from the TAP to allow data to be shifted into and out of the scan path via the TDI and TDO signals. The command register 40 of the scan path comprises a series of scan cells (flip-flops or latches) which can be loaded via a scan operation to output a command to the EQM controller 38. The loop counter section comprises a series of scan cells which can be loaded via a scan operation with a count value. When data is not being shifted through the loop counter 42, it can receive control from the controller 38 to operate as a count down counter. The loop counter 42 outputs a loop count minimum signal (LPCMIN) to the controller to indicate when it has counted down to a minimum count value.

The event counter section 44 comprises a series of scan cells which can be loaded via a scan operation with a count value. The count value loaded in the event counter 44 can be written to the event count memory 46 attached to the counter's parallel outputs to allow storing multiple count values. When data is not being shifted through the event counter 44 it can receive control from the controller 38 to operate as a count down counter. The event counter 44 outputs an event counter minimum signal (EVCMIN) to the controller to indicate when it has counted down to a minimum count value. Since the event counter 44 has a memory for storing multiple count values, it can receive control from the controller to load a new count value when the present count reaches a minimum value. This ability to reload new count values from the memory allows the EQM controller to execute sophisticated test protocols, as will be described later.

### EQM Controller

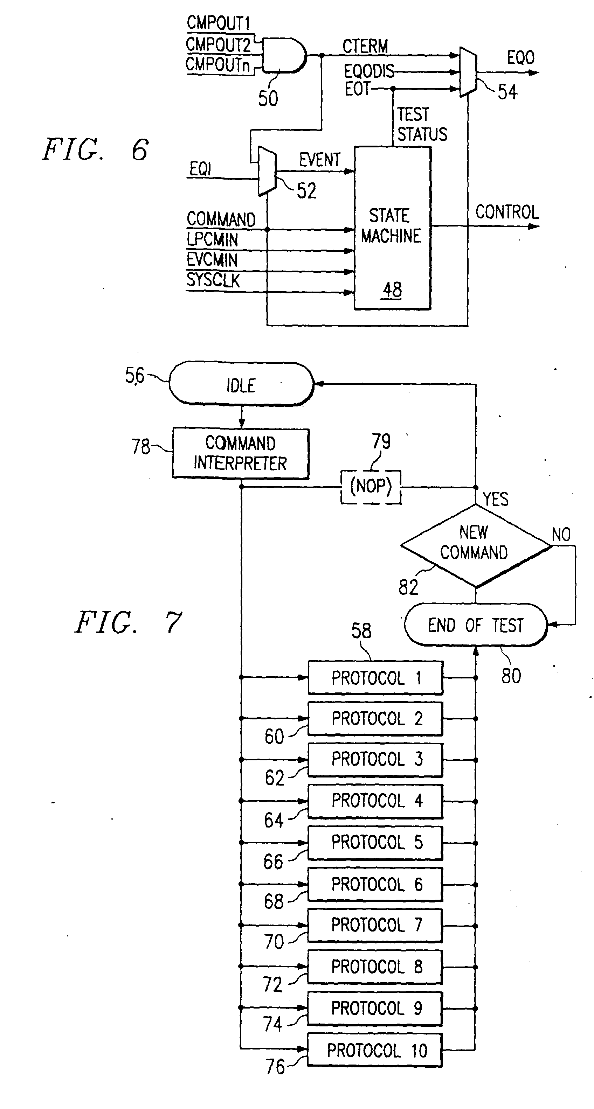

FIGURE 6 illustrates a block diagram of the EQM controller 38. The EQM controller 38 comprises a finite state machine 48, an AND gate 50 used for combining the CMPOUT signals into a single compare term signal (CTERM), a first multiplexer (Mux1) 52 for selecting the EVENT signal to be input to the state machine 48, and a second multiplexer (Mux2) 54 for selecting the signal to be output on the EQO output. The state machine 48 receives the EVENT signal from Mux1 52, the COMMAND input from the command register 40, the LPCMIN input from the loop counter 42, the EVCMIN input from the event counter 44, and the SYSCLK from the IC's function logic 18 or an input pin. The state machine 48 outputs control signals to the boundary test logic and the EQCs 24a-b and also outputs test status which can be selected and output on the EQO output, via Mux2 54.

The COMMAND input instructs the state machine 48 to execute a selected test protocol and controls the select input of Mux1 52 and Mux2 54. During the execution of a protocol, the state machine 48 monitors the EVENT output from Mux1 52. When Mux1 52 is set to output the CTERM as the EVENT signal, the state machine 48 monitors the CTERM signal to determine when to issue control to start and stop a test operation. The CTERM signal is selected by Mux1 52 when qualification of a test operation is based only on the local boundary conditions occurring at the host IC (see "Board Level-Local Event Qualification" section hereinbelow).

Alternately, when Mux1 52 is set to output the EQI input as the EVENT signal, the state machine 48 monitors the EQI signal to determine when to issue control to start and stop a test operation. The EQI signal is selected when qualification of a test operation is not based only on the local boundary conditions of the host IC, but rather over a range of IC boundary conditions and/or other external conditions generated on or input to the board design (see "Board Level - Global Event Qualification" section hereinbelow).

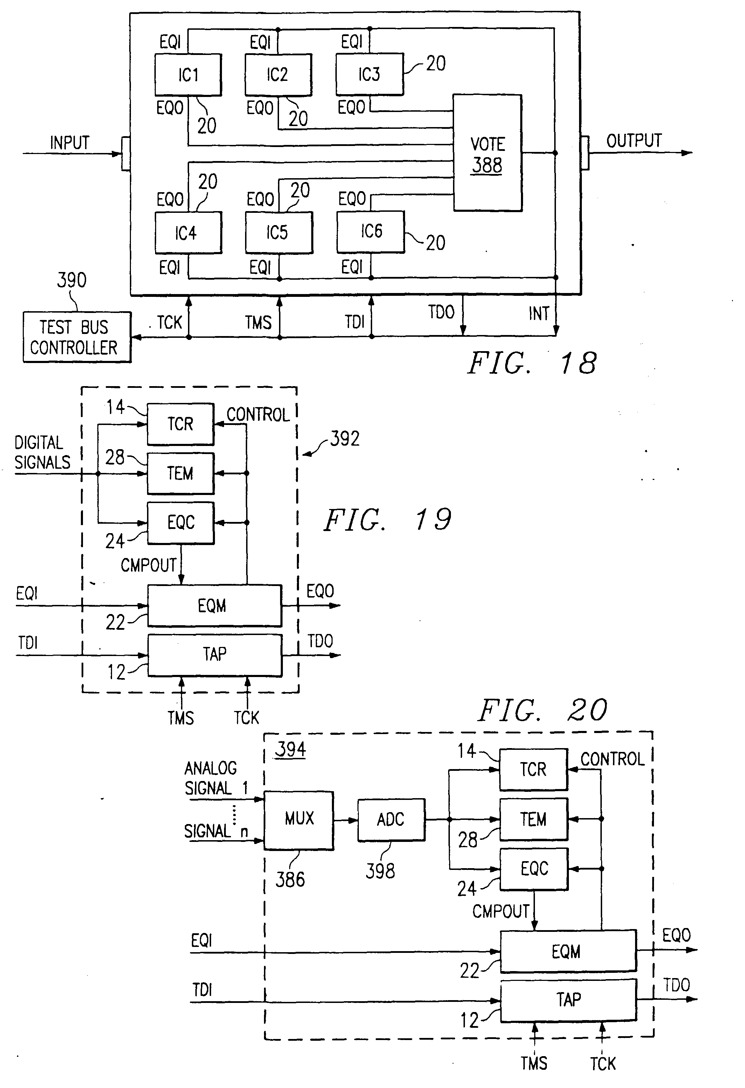

The command input also selects which of the CTERM signal, an end-of-test (EOT) status signal from the state machine 48, or an EQO disable (EQODIS) signal is output on the EQO pin via Mux2 54. The CTERM signal is selected and output on the EQO pin when the EQM is operating in a global qualification mode (see "Board Level - Global Event Qualification" section below). The EOT status signal is selected and output on the EQO pin when the EQM is operating in a local qualification mode (see "Board Level - Local Event Qualification" section below). The EOT signal goes active at the end of each protocol, indicating that the test operation controlled by the protocol is complete. When the EQODIS signal is selected and output on the EQO pin, the IC's EQO pin is disabled and has no affect on any external voting or other circuit to which it may be input (see Figure 18).

### EQM Controller Test Protocols

The state machine 48 of the EQM controller 38 contains commands for selecting and executing one of the test protocols shown in the state diagram of Figure 7 below. A no-operation (NOP) command is input to the EQM controller 38 when no test protocol is to be executed. Figure 7 illustrates how the state machine 48 decodes the COMMAND input to select one of the test protocols or the NOP command. When a protocol command is input, the state machine 48 leaves the Idle state 56 and enters one of the protocol 58-76 as interpreted by the command interpreter 78. During the execution of the protocol, the EQM outputs control that can be used to enable the test logic of the IC in Figure 2 to perform any of the test operations listed in Table 1. If no protocol is executed, the state machine 48 returns to the idle state 56 through the NOP command 79.

After a protocol has been executed, the "end of test" state 80 is entered prior to returning to the Idle state 56. The controller 38 will stay in the "end of test" state until the next command is input as shown by decision block 82. While in the "end of test" state the EOT status signal shown in Figure 6 is set and can be output from the EQO pin via Mux2. The reason for selecting the EOT signal to be output on the EQO pin is described in the "Board Level - Local Event Qualification" section of this specification.

All of the protocols 58-76 make use of the event and loop counters 44 and 42 shown in connection with the state machine of Figure 5. The event counter 44 is a count down counter used to either count the number of events or system clocks that are input to the state machine 48. When using the event counter 44 to count events, it is possible to cause the state machine 48 to respond to an "Nth" event, where N equals a count value loaded into the event counter 44, instead of on the first event. Being able respond to a programmable 1st, 2nd, or nth event to start and to stop a test operation enhances the event qualification architectures' ability to effectuate test or other operations in response to event inputs. The loop counter 42 is a count down counter primarily used to count the number of times a protocol is to be repeated. When the loop counter 42 is loaded with a count of "M" the protocol will repeat exactly "M" times.

### Protocol 1

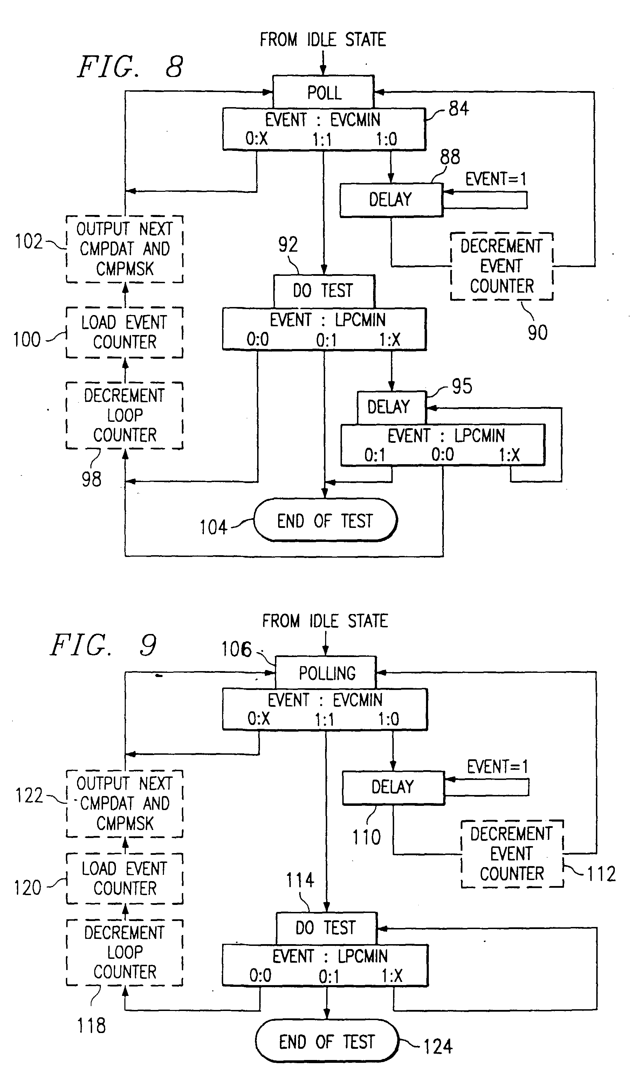

Protocol 1 allows a test or other procedure to occur once in response to an "Nth" event, and be repeated "M" times, as illustrated by the pseudo-code below and state diagram in Figure 8. For purposes of this specification, a "state" is a logical position in a state diagram. The states in a state diagram are illustrated as being directed such that one state transitions into one of the other states either automatically or in response to a condition input. The way the states are directed defines the function of the state diagram. States can exist as one of two types, temporary states and steady states. Temporary states are entered into on one clock and exited from on the next subsequent clock, i.e., a temporary state cannot loop back into itself. Steady states can be entered into on one clock and either exited from or looped back into on the next subsequent clock.

An "action" is a predefined operation performed when a state diagram transitions from one state to another state. The state machine outputs control to external logic to achieve the action. Actions are shown in the FIGUREs in dashed boxes.

During this protocol the event counter 44 of Figure 5 is used to delay the start of the operation until "N" occurrences of the event have been detected (state 84). Each time the state machine 48 detects the expected event (EVENT = 1), it checks the event counter's EVCMIN signal to see if the counter is at a minimum count (EVCMIN = 1). If an event is detected and the event counter 44 is not at a minimum count, the state machine 48 waits for the event input to go away (state 88) then decrements the event counter 44 once (action 90) and begins monitoring for the next occurrence of the same event. If an event is detected and the event counter 44 is at a minimum count, the state machine 48 issues control to execute a single test operation (state 92) and then waits for the event to finish (state 95).

The loop counter 42 is used to allow the above described protocol to be repeated "M" times. After each pass through the protocol, the state machine 48 checks the loop counter's LPCMIN signal to see if the loop counter 42 is at a minimum count (state 95). If the loop counter 42 is not at a minimum count (LPCMIN = 0), the state machine 48 decrements the loop counter 42 once (action 98), issues control to load a new "N" count into the event counter 44 (action 100), causes the memories in the EQCs to output a new pair of CMPDAT and CMPMSK signals (action 102), and repeats the protocol sequence described above. If the loop counter 42 is at a minimum count (LPCMIN = 1), the state machine 48 transitions into the "end of test" state 104 to terminate the protocol. The pseudo-code for Protocol 1 is:
For "M" times do:
Begin
On "Nth" event do test
End
End of Test

### Protocol 2

Protocol 2 operation allows a test or other procedure to occur while an "Nth" event is present and repeated "M" times, as illustrated by the pseudo-code below and the state diagrams in Figure 9.

During this protocol the event counter 44 of Figure 5 is used to delay the start of the operation until "N" occurrences of the event have been detected. Each time the state machine 48 detects the expected event, it checks the event counter's EVCMIN signal to see if the counter is at a minimum count (state 106). If an event is detected and the event counter 44 is not at a minimum count in state 106, the state machine 48 waits for the event input to go away (state 110), then decrements the event counter 44 once (action 112) and begins monitoring for the next occurrence of the same event. If an event is detected and the event counter 44 is at a minimum count, the state machine 48 issues control to execute a test operation while the event input is present (state 114). When the event input goes away, the state machine 48 terminates the test operation.

The loop counter 42 is used to allow the above described protocol to be repeated "M" times. After each pass through the protocol, the state machine 48 checks the loop counter's LPCMIN signal (state 114) to see if the counter is at a minimum count. If the loop counter 42 is not at a minimum count, the state machine 48 decrements the loop counter 42 once (action 118), issues control to load a new "N" count into the event counter 44 (action 120), causes the memories in the EQCs to output a new pair of CMPDAT and CMPMSK signals (action 122), and repeats the protocol sequence described above. If the loop counter 42 is at a minimum count, the state machine 48 transitions into the "end of test" state 124 to terminate the protocol.

The pseudo-code for Protocol 2 is:
For "M" times do
Begin
During "Nth" event do test
End
End of test

### Protocol 3

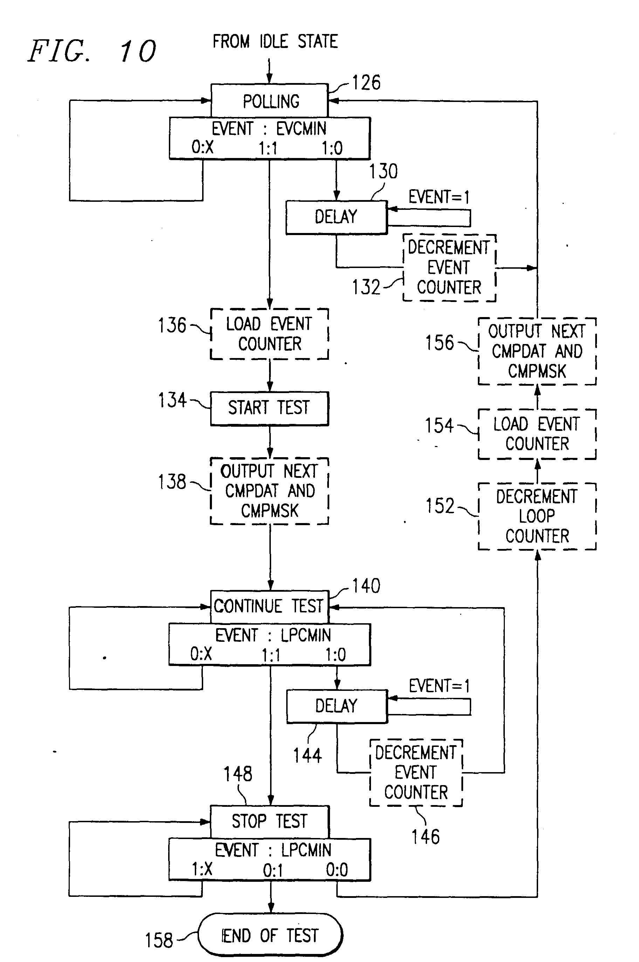

Protocol 3 operation allows a test or other procedure to be started in response to a first "Nth" event, stopped in response to a second "Nth" event, and repeated "M times, as illustrated by the pseudo-code below and state diagrams in Figure 10.

During this protocol, the event counter 44 of Figure 5 is used to delay the start of the operation until "N" occurrences of a first event have been detected. Each time the state machine 48 detects the expected first event it checks the event counter's EVCMIN signal to see if the counter is at a minimum count (state 126). If an event is detected and the event counter 44 is not at a minimum count, the state machine 48 waits for the event input to go away (state 130) then decrements the event counter 44 once (action 132) and begins monitoring for the next occurrence of the same event. If an event is detected and the event counter 44 is at a minimum count, the state machine 48 issues control to start a test operation (state 134). When the detected event that starts the test operation goes away, the state machine 48 issues control to load the event counter 44 with a new "N" count (action 136) and to cause the memories inside the EQCs to output a new pair of CMPDAT and CMPMSK signals (action 138) to be used to compare against a second "Nth" event that will stop the test operation (state 140).

While the state machine 48 monitors for the second "Nth" event that will stop the test operation (state 140), it continues issuing control to maintain the test operation. Each time the state machine 48 detects a second event it checks the event counter's EVCMIN signal to see if the counter is at a minimum count. If an event is detected and the event counter 44 is not at a minimum count, the state machine 48 waits for the event input to go away (state 144) then decrements the event counter 44 once and begins monitoring for the next occurrence of the same event (action 146). If an event is detected and the event counter 44 is at a minimum count, the state machine 48 issues control to stop the test operation (state 148).

The loop counter 42 is used to allow the above described protocol to be repeated "M" times. After each pass through the protocol, the state machine 48 checks the loop counter's LPCMIN signal to see if the counter is at a minimum count (state 148). If the loop counter 42 is not at a minimum count, the state machine 48 decrements the loop counter 42 once (action 152), issues control to load a new "N" count into the event counter 44 (action 154), causes the memories in the EQCs to output a new pair of CMPDAT and CMPMSK signals (action 156), and repeats the protocol sequence described above. If the loop counter 42 is at a minimum count, the state machine 48 transitions into the "end of test" state 158 to terminate the protocol.

The pseudo-code for Protocol 3 is:
For "M" times do
Begin
On "Nth" event start test
On "Nth" event stop test
End
End of test

### Protocol 4

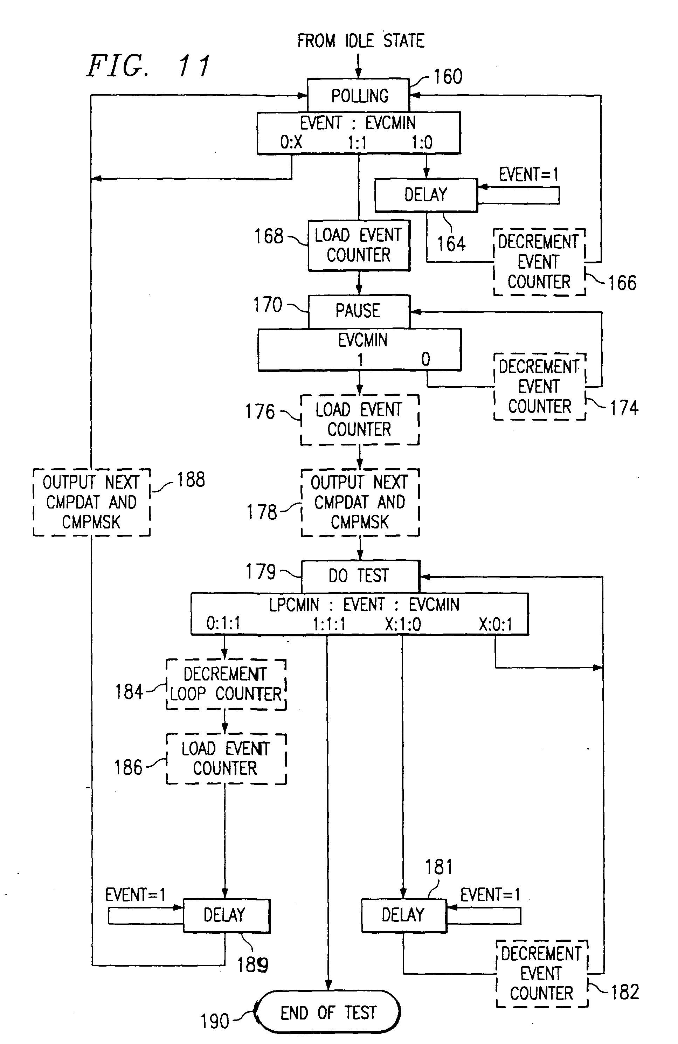

Protocol 4 operation allows a test or other procedure to be started "N" clocks after the detection of a first "Nth" event, stopped in response to a second "Nth" event, and repeated "M" times as illustrated by the pseudo-code below and state diagram in Figure 11.

During this protocol, the event counter 44 of Figure 5 is used to delay the start of the operation until "N" occurrences of a first event have been detected. Each time the state machine 48 detects the expected first event it checks the event counter's EVCMIN signal to see if the counter is at a minimum count (state 160). If an event is detected and the event counter 44 is not at a minimum count, the state machine 48 waits for the event input to go away (state 164) then decrements the event counter 44 once (action 166) and begins monitoring for the next occurrence of the first event. If an event is detected and the event counter 44 is at a minimum count, the state machine 48 loads a new "N" count into the event counter 44 (action 168) and begins decrementing the event counter 44 once for each system clock input (state 170 and action 174).

When the event counter 44 reaches a minimum count, indicated by the EVCMIN signal, the state machine 48 issues control to start the test operation, load the event counter 44 with a new "N" count (action 176), and cause the memories inside the EQCs to output a new pair of CMPDAT and CMPMSK signals (action 178) to be used to compare against a second "Nth" event that will stop the test operation. The ability to delaying the start of a test operation for a predetermined number of clocks allows starting the test operation (state 179) at some point in time after the starting event occurs.

After the test is started the state machine 48 uses the event counter 44 to delay stopping the test operation until "N" occurrences of the second event have been detected. Each time the state machine 48 detects the expected second event it checks the event counter's EVCMIN signal to see if the counter is at a minimum count (state 170). If an event is detected and the event counter 44 is not at a minimum count, the state machine 48 waits for the event input to go away (state 181) then decrements the event counter 44 once and begins monitoring for the next occurrence of the second event (action 182). If an event is detected and the event counter 44 is at a minimum count, the state machine 48 issues control to stop the test operation.

The loop counter 42 is used to allow the above described protocol to be repeated "M" times. After each pass through the protocol, the state machine 48 checks the loop counter's LPCMIN signal to see if the counter is at a minimum count. If the loop counter 42 is not at a minimum count, the state machine 48 decrements the loop counter 42 once (action 184), issues control to load a new "N" count into the event counter 44 (action 186), causes the memories in the EQCs to output a new pair of CMPDAT and CMPMSK signals (action 188), and repeats the protocol sequence described above after the event goes away (state 189). If the loop counter 42 is at a minimum count, the state machine 48 transitions into the "end of test" state to terminate the protocol (state 190).

The pseudo-code for Protocol 4 is:
For "M" times do
Begin
On "Nth" event start test after "N" clocks
On "Nth" event stop test
End
End of test

### Protocol 5

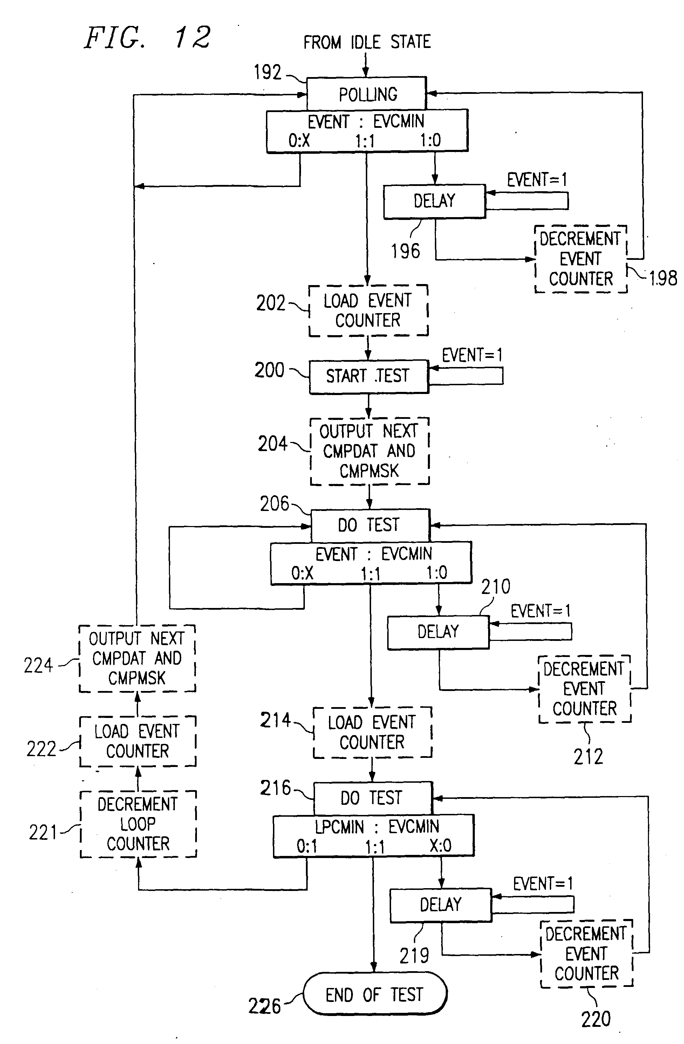

Protocol 5 operation allows a test or other procedure to be started in response to a first "Nth" event, stopped "N" clocks after the detection of a second "Nth" event, and repeated "M" times as illustrated by the pseudo-code below and state diagrams in Figure 12.

During this protocol, the event counter 44 of Figure 5 is used to delay the start of the operation until "N" occurrences of a first event have been detected. Each time the state machine 48 detects the expected first event it checks the event counter's EVCMIN signal to see if the counter is at a minimum count (state 192). If an event is detected and the event counter 44 is not at a minimum count, the state machine 48 waits for the event input to go away (state 196) then decrements the event counter 44 once (action 198) and begins monitoring for the next occurrence of the first event. If an event is detected and the event counter 44 is at a minimum count, the state machine 48 issues control to start the test operation (state 200), load a new "N" count into the event counter 44 (action 202) and cause the memories inside the EQCs to output a new pair of CMPDAT and CMPMSK signals (action 204) to be used to compare against a second "Nth" event that will initiate the stoppage sequence of the test operation.

After the test is started the state machine 48 uses the event counter 44 to delay stopping the test operation until "N" occurrences of the second event have been detected. Each time the state machine 48 detects the expected second event it checks the event counter's EVCMIN signal to see if the counter is at a minimum count (state 206). If an event is detected and the event counter 44 is not at a minimum count, the state machine 48 waits for the event input to go away (state 210) then decrements the event counter 44 once (action 212) and begins monitoring for the next occurrence of the second event. If an event is detected and the event counter 44 is at a minimum count, the state machine 48 loads a new "N" count into the event counter 44 (action 214) and begins decrementing the event counter 44 once for each system clock input (states 216 and 219 and action 220). When the event counter 44 reaches a minimum count, indicated by the EVCMIN signal, the state machine 48 issues control to stop the test operation. The capability of delaying the stopping of a test operation for a predetermined number of clocks allows stopping the test operation at some point in time after the stopping event occurs.

The loop counter 42 is used to allow the above described protocol to be repeated "M" times. After each pass through the protocol, the state machine 48 checks the loop counter's LPCMIN signal to see if the counter is at a minimum count (state 216). If the loop counter 42 is not at a minimum count, the state machine 48 decrements the loop counter 42 once (action 221), issues control to load a new "N" count into the event counter 44 (action 222), causes the memories in the EQCs to output a new pair of CMPDAT and CMPMSK signals (action 224), and repeats the protocol sequence described above. If the loop counter 42 is at a minimum count, the state machine 48 transitions into the "end of test" state 226 to terminate the protocol.

The pseudo-code for Protocol 5 is:
For "M" times do
Begin
On "Nth" event start test
On "Nth" event stop test after "N" clocks
End
End of test

### Protocol 6

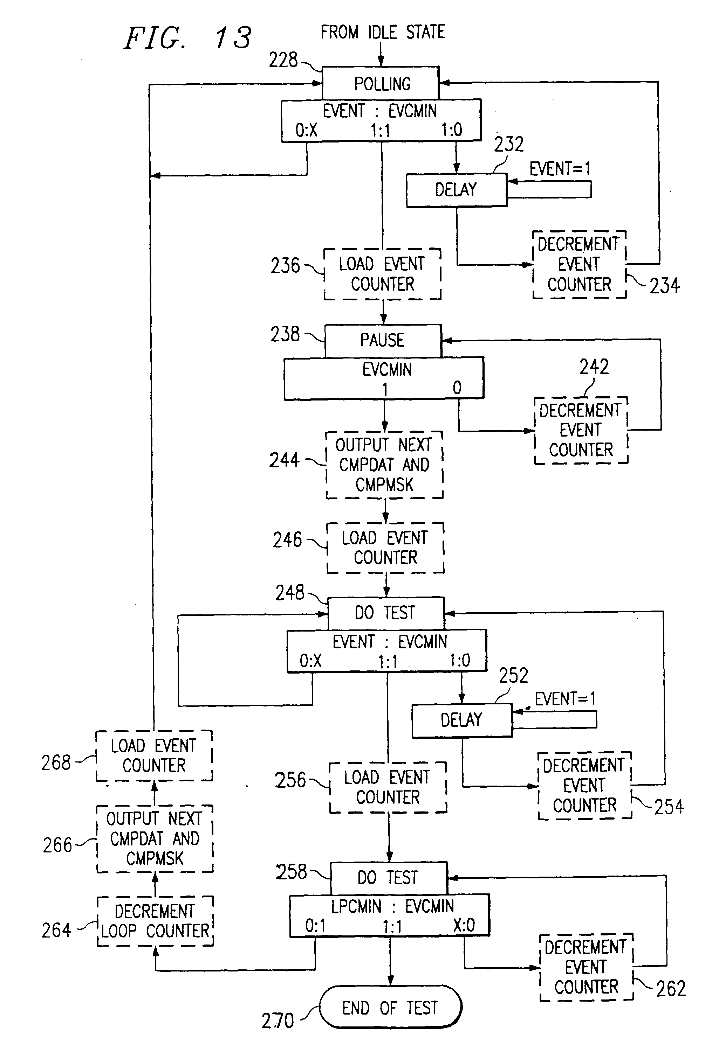

Protocol 6 operation allows a test or other procedure to be started "N" clocks after the detection of a first "Nth" event, stopped "N" clocks after the detection of a second "Nth" event, and repeated "M" times as illustrated by the pseudo-code below and state diagrams in Figure 13.

During this protocol, the event counter 44 of Figure 5 is used to delay the start of the operation until "N" occurrences of a first event have been detected. Each time the state machine 48 detects the expected first event it checks the event counter's EVCMIN signal to see if the counter is at a minimum count (state 228). If an event is detected and the event counter 44 is not at a minimum count, the state machine 48 waits for the event input to go away (state 232) then decrements the event counter 44 once (action 234) and begins monitoring for the next occurrence of the first event. If an event is detected and the event counter 44 is at a minimum count, the state machine 48 loads a new "N" count into the event counter 44 (action 236) and begins decrementing the event counter 44 once for each system clock input (state 238 and action 242).

When the event counter 44 reaches a minimum count, indicated by the EVCMIN signal, the state machine 48 loads the event counter 44 with a new "N" count (action 244), causes the memories inside the EQCs to output a new pair of CMPDAT and CMPMSK signals (action 246) to be used to compare against a second "Nth" event that will initiate the stoppage sequence the test operation and issues control to start the test operation (state 248). The capability of delaying the start of a test operation for a predetermined number of clocks allows starting the test operation at some point in time after the starting event.

After the test is started the state machine 48 uses the event counter 44 to delay stopping the test operation until "N" occurrences of the second event have been detected (state 248). Each time the state machine 48 detects the expected second event it checks the event counter's EVCMIN signal to see if the counter is at a minimum count. If an event is detected and the event counter 44 is not at a minimum count, the state machine 48 waits for the event input to go away (state 252) then decrements the event counter 44 once (action 254) and begins monitoring for the next occurrence of the second event. If an event is detected and the event counter 44 is at a minimum count, the state machine 48 loads a new "N" count into the event counter 44 (action 256) and begins decrementing the event counter 44 once for each system clock input. When the event counter 44 reaches a minimum count (state 258 and action 262), indicated by the EVCMIN signal, the state machine 48 issues control to stop the test operation. The capability of delaying the stopping of a test operation for a predetermined number of clocks allows stopping the test operation at some point in time after the stopping event.

The loop counter 42 is used to allow the above described protocol to be repeated "M" times. After each pass through the protocol, the state machine 48 checks the loop counter's LPCMIN signal to see if the counter is at a minimum count (state 258). If the loop counter 42 is not at a minimum count, the state machine 48 decrements the loop counter 42 once (action 264), issues control to load a new "N" count into the event counter 44 (action 266), causes the memories in the EQCs to output a new pair of CMPDAT and CMPMSK signals (action 268), and repeats the protocol sequence described above. If the loop counter 42 is at a minimum count, the state machine 48 transitions into the "end of test" state 270 to terminate the protocol.

The pseudo-code for Protocol 6 is:
For "M" times do
Begin
On "Nth" event start test after "N" clocks
On "Nth" event stop test after "N" clocks
End
End of test

### Protocol 7

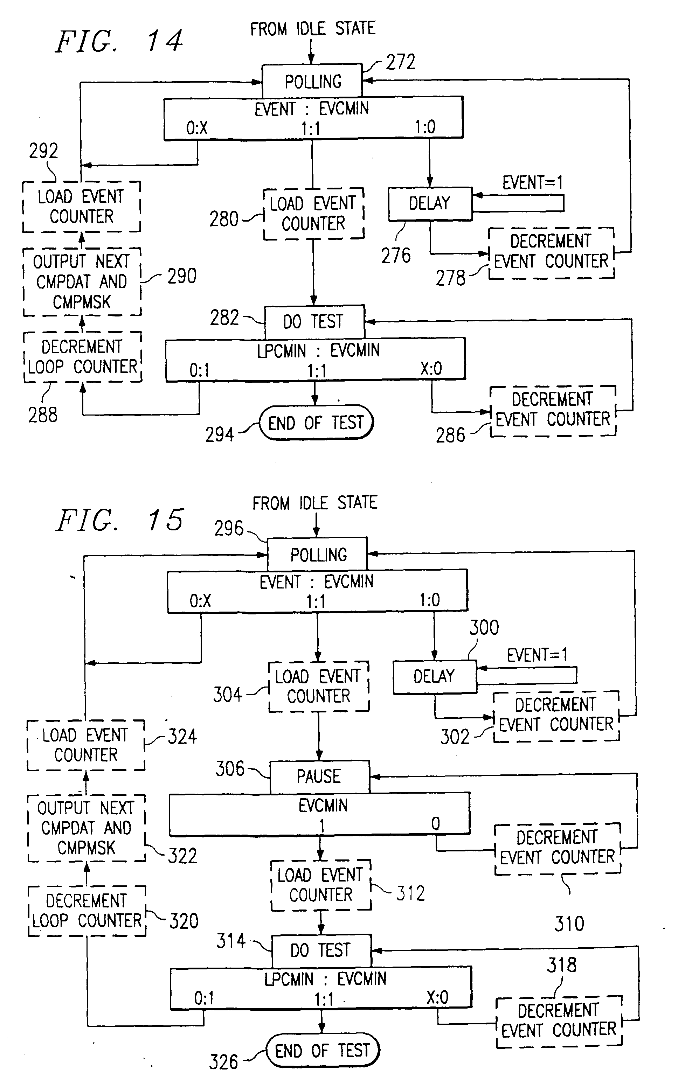

Protocol 7 operation allows a test or other procedure to be started in response to a first "Nth" event, stopped after "N" system clocks, and repeated "M times, as illustrated by the pseudo-code below and state diagrams in Figure 14.

During this protocol the event counter 44 of Figure 5 is used to delay the start of the operation until "N" occurrences of a first event have been detected. Each time the state machine 48 detects the expected first event it checks the event counter's EVCMIN signal to see if the counter is at a minimum count (state 272). If an event is detected and the event counter 44 is not at a minimum count, the state machine 48 waits for the event input to go away (state 276) then decrements the event counter 44 once (action 278) and begins monitoring for the next occurrence of the same event. If an event is detected and the event counter 44 is at a minimum count, the state machine 48 issues control to load the event counter 44 with a new "N" count equal to the number of system clocks that the test will be executed for (action 280) and to start a test operation (state 282). During the test, the event counter 44 is decremented once during each system clock input (state 282 and action 286). When the event counter 44 reaches a minimum count the state machine 48 stops the test operation.

The loop counter 42 is used to allow the above described protocol to be repeated "M" times. After each pass through the protocol, the state machine 48 checks the loop counter's LPCMIN signal to see if the counter is at a minimum count (state 282). If the loop counter 42 is not at a minimum count, the state machine 48 decrements the loop counter 42 once (action 288), issues control to load a new "N" count into the event counter 44 (action 290), causes the memories in the EQCs to output a new pair of CMPDAT and CMPMSK signals (action 292), and repeats the protocol sequence described above. If the loop counter 42 is at a minimum count, the state machine 48 transitions into the "end of test" state 294 to terminate the protocol.

The pseudo-code for Protocol 7 is:
For "M" times do
Begin
On "Nth" event do test for "N" clocks
End
End of test

### Protocol 8

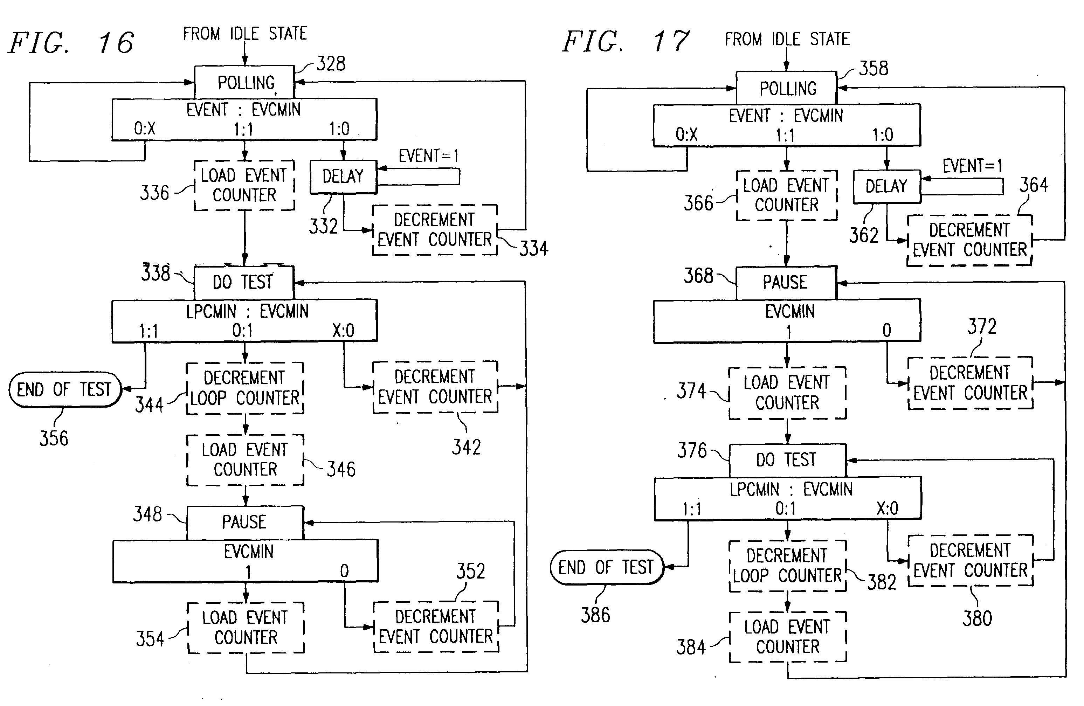

Protocol 8 operation allows a test or other procedure to be started "N" system clocks after the detection of an "Nth" event, stopped after "N" systems clocks, and-repeated "M" times as illustrated by the pseudo-code below and state diagram of Figure 15.

During this protocol, the event counter 44 of Figure 5 is used to delay the start of the operation until "N" occurrences of an expected event have been detected. Each time the state machine 48 detects the expected event it checks the event counter's EVCMIN signal to see if the counter 44 is at a minimum count (state 296). If an event is detected and the event counter 44 is not at a minimum count, the state machine 48 waits for the event input to go away (state 300) then decrements the event counter 44 once (action 302) and begins monitoring for the next occurrence of the expected event. If an event is detected and the event counter 44 is at a minimum count, the state machine 48 loads a new "N" count into the event counter 44 (action 304). The "N" count is equal to the number of system clock cycles that must occur before the test operation can be started.

After the new count is loaded, the state machine 48 decrements the event counter 44 once for each system clock input it receives (state 306 and action 310). When the event counter 44 reaches a minimum count, indicated by the EVCMIN signal, the state machine 48 reloads the event counter 44 with a new "N" count equal to the number of system clock cycles that the test operation will execute for (action 312) and issues control to start the test operation (state 314). After the new count is loaded, the state machine 48 decrements the event counter 44 once for each system clock input it receives (state 314 and action 318). When the event counter 44 reaches a minimum count, the state machine 48 issues control to stop the test operation.

The loop counter 42 is used to allow the above described protocol to be repeated "M" times. After each pass through the protocol, the state machine 48 checks the loop counter's LPCMIN signal to see if the counter 42 is at a minimum count. If the loop counter 42 is not at a minimum count, the state machine 48 decrements the loop counter 42 once (action 320), issues control to load a new "N" count into the event counter 44 (action 322), causes the memories in the EQCs to output a new pair of CMPDAT and CMPMSK signals (action 324), and repeats the protocol sequence described above. If the loop counter 42 is at a minimum count, the state machine 48 transitions into the "end of test" state 326 to terminate the protocol.

The pseudo-code for Protocol 8 is:
For "M" times do
Begin
On "Nth" event;
Pause of "N" clocks
Do test for "N" clocks
End
End of test

### Protocol 9

Protocol 9 operation allows a test or other procedure to be started in response to an "Nth" event, execute for "N" system clocks, then, if the loop counter 42 is not at a minimum count, pause for "N" system clocks before resuming the test again, as shown in the pseudo-code below and state diagram in Figure 16.

During this protocol the event counter 44 of Figure 5 is used to delay the start of the operation until "N" occurrences of a first event have been detected. Each time the state machine 48 detects the expected event it checks the event counter's EVCMIN signal to see if the counter is at a minimum count (state 328). If an event is detected and the event counter 44 is not at a minimum count, the state machine 48 waits for the event input to go away (state 332) then decrements the event counter 44 once (action 334) and begins monitoring for the next occurrence of the same event. If an event is detected and the event counter 44 is at a minimum count, the state machine 48 issues control to load the event counter 44 with a new "N" count equal to the number of system clocks that the test will be executed for (action 336) and to start a test operation (state 338). During the test, the event counter 44 is decremented once during each system clock input (state 338 and 342).

When the event counter 44 reaches a minimum count the state machine 48 stops the test operation and checks to see if the loop counter 42 is at a minimum count. Depending on whether the loop counter 42 is at a minimum count, the state machine takes one of two possible actions. In the first action where the loop counter 42 is not at a minimum count, as determined by checking the LPCMIN signal, the state machine 48 decrements the loop counter 42 once (action 344) then loads a new "N" count into the event counter 44 equal to the number of system clocks the test operation is to be paused (action 346). The event counter 44 is decremented once for each system clock input (state 348 and action 352). When the event counter 44 reaches a minimum count, a new "N" count is loaded into the event counter 44 (action 354) and the test operation is resumed until the event counter 44 once again reaches a minimum count, at which time the loop counter 42 is tested again for a minimum count as mentioned above. In the second action where the loop counter 42 is at a minimum count the protocol is terminated and the state machine 48 transitions into the "end of test" state 356.

The pseudo-code for Protocol 9 is:
On "Nth" event do;
Do test for "N" clocks
Then For (M-1) times do
Begin
Pause for "N" clocks
Do test for "N" clocks
End
End of test

### Protocol 10

Protocol 10 operation allows a test or other procedure to be initiated in response to an "Nth" event. Once initiated, the protocol will pause for "N" system clocks, execute for "N" system clocks, and repeat the pause and execute sequence "M" times as shown in the pseudo-code below and state diagram of Figure 18.

During this protocol, the event counter 44 of Figure 6 is used to delay the start of the operation until "N" occurrences of a first event have been detected. Each time the state machine 48 detects the expected event it checks the event counter's EVCMIN signal to see if the counter 44 is at a minimum count (state 358). If an event is detected and the event counter 44 is not at a minimum count, the state machine 48 waits for the event input to go away (state 362) then decrements the event counter 44 once (action 364) and begins monitoring for the next occurrence of the same event. If an event is detected and the event counter 44 is at a minimum count, the state machine 48 issues control to load the event counter 44 with a new "N" count equal to the number of system clocks that the actual start of the test will be delayed or paused for (action 366). During the pause operation, the event counter 44 is decremented once during each system clock input (state 368 and action 372).

When the event counter 44 reaches a minimum count, the state machine 48 issues control to start the test and load a new "N" count into the event counter 44 (action 374). During the test operation, the event counter 44 is decremented once during each system clock input (state 376 and action 380). When the event counter 44 reaches a minimum count, as determined by monitoring the EVCMIN signal, the state machine 48 stops the test operation checks the loop counter's LPCMIN signal to see if the loop counter 42 is at minimum count. If the loop counter 42 is not at a minimum count the state machine 48 decrements the loop counter 42 (action 382), loads a new "N" count into the event counter 44 (action 384) and repeats the above described (pause for "N" then test for "N") sequence. If the loop counter 42 is at a minimum count the state machine 48 will terminate the protocol and transition into the "end of test" state 386.
The pseudo-code for Protocol 10 is:
On "Nth" event;
For "M" times do
Begin
Pause for "N" clocks
Do Test for "N" CLOCKS
End
End of test

### Board Level Event Qualification

The event qualification architecture has been described hereinabove as it applies locally to the boundary of one IC. This section of the disclosure describes how multiple ICs can participate in the event qualification process. Figure 18 illustrates a board design comprising multiple ICs 20 which include the event qualification architecture shown in Figure 2 along with a voting circuit 388. The voting circuit is required for board level qualification and is used to combine all the EQO signals from each IC into a single signal that is fed back into each IC via the EQI input.

The board has input and output for system data, a 4-wire 1149.1 test bus interface (TCK< TMS< TDI and TDO signals), and an interrupt (INT) for outputting event signals. The 4-wire test bus and INT signal are coupled to a test bus controller 390. The test bus controller 390 serially accesses the ICs 20 on the board design, via the 1149.1 test bus, to set up and execute test operations and to extract test data obtained from the tests.

### Board Level - Local Event Qualification

The ICs 20 in Figure 18 can be set up for local qualification and test operations by scan access from the 1149.1 test bus controller. When the ICs 20 operate in local qualification mode, the test each IC performs is qualified only by the conditions occurring local to the IC's boundary. In this mode, all the ICs 20 of Figure 18 can be made to concurrently execute individual test operations, with each test operation potentially being controlled by a different type of event qualification protocol. For example, some of the ICs can be set up to compress input and output data into their TCRs 14 and 16 using event qualification Protocol 3, while other ICs are set up to store input data into their internal TMEM 28 using event qualification Protocol 2.

During local qualification, the EQM state machine 48 selects the CTERM, shown in Figure 6, to be the source of the event it monitors to start and stop a test protocol. The CTERM indicates the status of local compare operations occurring at the boundary of the host IC. Thus in local qualification mode, a protocol can be started and stopped only in response to compare operations occurring at the host ICs boundary.

Also during local qualification, the EQO outputs from each IC 20 are set to output the EOT status signal from the EQM state machine 48 in Figure 6. The voting circuit 388 receives the EQO signals and outputs an EQI signal which is fed back to each IC's EQI input. The EQI output from the voting circuit 388 is also fed off-board via the INT signal. The voting circuit does not output the EQI signal until all ICs 20 have completed their local test operations (protocols) and have output an EOT status signal from their EQO outputs. By monitoring the INT output the test bus controller 390 can determine when all the test operations performed by each IC 20 has been completed. When the INT signal is detected, the test bus controller 390 executes scan operations to extract the test data collected in each IC for examination.

### Board Level - Global Event Qualification

While local qualification serves many testing needs, there are times when the qualification of a test needs to be expanded beyond the boundary of the target IC. Increasing the number of boundary signals participating in the qualification process improves the resolution as to when a test operation is enabled. For example, the signals at one ICs boundary may not provide sufficient qualification for a particular test operation. However, by combining the boundary signals of neighboring ICs with the boundary signals of the target IC, a global qualification mode is obtained which can be used to more accurately enable the test operation.

During global qualification, the EQO signal from each IC 20 is set to output the result of the IC's local boundary compare operation. The EQO signals from all the ICs 20 are input to the voting circuit 388 so they can be combined into one composite global compare signal. Any IC that does not participate sets its EQO output to a state that will not interfere with the operation of the voting circuit (see EQODIS input to Mux2 54 in FIGURE 6). The output of the voting circuit 388 is fed back into each IC's EQI input, to allow the EQM inside each IC 20 to monitor for the occurrence of a global compare signal.

Each time a match occurs across all the IC boundaries, the EQO outputs from the ICs 20 will all be enabled and the voting circuit 388 will output a global compare signal back to each IC's EQI input. The EQMs 22 of each IC 20 respond to the EQI inputs to execute a protocol to control a predetermined test operation. By monitoring the INT output the test bus controller 390 can determine when the global test operation is complete so that the test data obtained can be scanned out of the ICs for inspection.

### Using only the EOM in IC designs

While this disclosure has described the event qualification architecture as comprising both the EQCs 24 and the EQM 22, it is possible to only use the EQM 22 when there is not enough logic in the IC to implement the EQCs 24. When only the EQM 22 is used, the EQI input serves as the single event input to start and stop the EQM's protocols. The operation of the EQM remains the same, the only difference is that the qualification of a test operation must always be input to the IC, via the EQI pin, instead of optionally being generated inside the IC. Since no internal qualification occurs when an IC does not include the EQCs, or similar compare circuitry, the EQO pin is used to only output either the EOT status signal from the EQM controller 38 or the EQODIS signal via Mux2 54 (see Figure 6).

### Using the architecture in different IC architectures

While this disclosure has illustrated the event qualification architecture as being included in the typical IC architecture of Figure 2, it can be used in other types of IC architectures as well. Two IC architectures implementing the architecture are shown in Figures 19 and 20. These IC architectures differ from the one shown in Figure 2 in that they only have input signals, test logic to receive the input signals, and the event qualification architecture.

### Digital Signal Monitor

The digital signal monitor IC 392 of Figure 19 comprises a TCR 14, TMEM 28, EQCs 24, EQM 22, and a TAP interface 12. The TAP provides serial access to the IC 392 for setting up test operations and extracting test results. The digital signals are input to the TCR 14 and TMEM 28 for monitoring and to the EQCs 24 for comparison against expected data. In operation, the EQM 22 receives an event input from either the EQCs 24 or from the EQI input to start execution of a predetermined protocol. When an event is received the protocol starts and the EQM 22 outputs control to cause the TCR 14 and TMEM 28 to start monitoring data. The TCR 14 can be set to sample a single data input pattern or compress a stream of data input patterns. The TMEM 28 can be set to store multiple data input patterns. When the protocol is complete, the EQM 22 outputs control to the TCR 14 and TMEM 28 causing them to stop monitoring data. After the test is complete the data stored in the TCR 14 and TMEM 28 can be scanned out via the TAP interface for examination.

### Analog Signal Monitor

The analog signal monitor IC 394 of Figure 20 comprises a TCR 14, TMEM 28, EQCs 24, EQM 22, TAP 12, analog multiplexer 396, and an analog-to-digital converter (ADC) 398. The analog signal monitor 394 receives multiple analog signal inputs into the analog multiplexer 396. The multiplexer selects one of the analog signal inputs to be input to the ADC 398. The ADC 398 converts the analog signal input into a digital pattern representative of the voltage of the analog signal. After one conversion is complete the conversion is repeated. Thus as the voltage of the analog signal changes, the digital output of the ADC 398 changes to reflect the new voltage of the analog signal. After the analog signal is converted into a digital form, the analog monitor operates exactly like the digital signal monitor of Figure 19.

The digital pattern output from the ADC 398 is input to the TCR 14 and TMEM 28 for monitoring and to the EQCs 24 for comparison against expected data. The EQM 22 receives an event input from either the EQCs 24 or from the EQI input to start execution of a predetermined protocol. When an event is received the protocol starts and the EQM outputs control to cause the TCR 14 and TMEM 24 to start monitoring the digital pattern outputs from the ADC. The TCR can be set to sample a single digital pattern or compress a stream of digital patterns. The TMEM 24 can be set to store multiple digital patterns. When the protocol is complete, the EQM 22 outputs control to the TCR 14 and TMEM 24 causing them to stop monitoring data. After the test is complete the data stored in the TCR 14 and TMEM 24 can be scanned out via the TAP interface for examination.

The present invention overcomes the problems described in the 1149.1 Sample instruction and provides methods to perform other test functions beyond just sampling single data patterns. Since the present invention may be embedded in the IC itself, no external circuitry must be added to the circuit board to provide synchronization and qualification of external control inputs to perform an on-line test operation. Also, when the present invention is enabled to control a test operation, it operates independent from the IC's TAP, allowing different ICs to operate different tests at different times. Having local test control in each IC instead of a global test control input to all ICs, de-centralizes testing at the circuit board level.

Importantly, the present invention's ability to enable boundary test logic while the host IC is operating normally, allows testing the at-speed data transfers between ICs on a board design. Using this approach, it is possible to detect timing sensitive and/or intermittent data transfer failures that may occur between multiple ICs in a functioning circuit. These types of failures are very difficult if not impossible to detect without physically probing the board design.

In state-of-the-art board designs, using surface mount technology, physical access to probe a functioning board is usually very limited and in some cases does not exist at all. Also, in circuits designed using very high speed technologies, the electrical load associated with a probing instrument can affect the operation of the signals being probed, causing the circuit to malfunction.

The present invention provides an alternate method to test for at-speed related problems when physical probing of the board design is not possible or when probing affects the operation of the board. Since the present invention may be designed into ICs it remains in the product after it leaves the factory test floor. Thus it can be reused during other phases of the products life cycle such as; system integration, environmental testing, and field service and repair.

Although the preferred embodiment of the present invention has been described in detail, it should be understood that various changes, substitutions and alterations can be made herein without departing from the invention as defined by the appended claims.

## Claims

1. A method of testing a circuit comprising the steps of:
providing at least one event qualification cell (24a) having an internal memory (32) and having compare circuitry (30) for comparing data input into the compare circuitry (30) with data stored in said internal memory (32);
operating said event qualification cell (24a) for detecting each occurrence of a specified event;
counting the number of occurrences of the specified event;
executing a test responsive to detecting a predetermined number of occurrences of the specified event; and
executing said test for a predetermined number of clock cycles.

2. The method of Claim 1 and further comprising the step of repeating said counting and executing steps a predetermined number of times wherein the predetermined number of occurrences of the specified event may vary on each repetition.

3. The method of Claim 1 and further comprising the steps of:
detecting a second specified event;
counting the number of occurrences of the second specified event; and
stopping the test responsive to detection of a predetermined number of occurrences of the second specified event.

4. The method of Claim 3 and further comprising the step of repeating a predetermined number of times said steps of counting the number of occurrences of the first specified event, executing a test, counting the number of occurrences of the second specified event and stopping the test wherein the predetermined number of occurrences of the first specified event and the predetermined number of occurrences second specified event may vary on each repetition.

5. The method of Claim 3 wherein said stopping test step comprises the step of stopping the test responsive to detecting a predetermined number of clock cycles after a predetermined number of occurrences of the second specified event.

6. The method of Claim 5 and further comprising the step of repeating a predetermined number of times said steps of counting the number of occurrences of the first event, executing a test responsive to detection of a predetermined number of occurrences of the first event, counting the number of occurrences of the second event, and stopping the test after detection of a predetermined number of occurrences of the second event wherein the predetermined number of occurrences of the first specified event, the predetermined number of clock cycles and the predetermined number of occurrences of the second specified event may vary on each repetition.

7. The method of Claim 5 wherein said step of starting the test comprises the steps of pausing a predetermined number of clock cycles after detecting the predetermined number of occurrences of said first event and executing the test after pausing.

8. The method of Claim 7 and further comprising the step of repeating a predetermined number of times said steps of counting the number of occurrences of the first event, pausing a predetermined number of clock cycles after detection of a predetermined number of occurrences of the first event, executing the test after pausing, counting the number of occurrences of the second event, and stopping the test after detection of a predetermined number of occurrences of the second event wherein the predetermined number of occurrences of the first specified event, predetermined number of occurrences of the second specified event, predetermined number of pausing clock cycles and predetermined number of clock cycles after detecting said first event may vary on each repetition.

9. The method of Claim 1 wherein said executing step further comprises the steps of pausing the test for a predetermined number of clocks and resuming the test for a predetermined number of clock cycles.

10. The method of Claim 9 and further comprising the step of repeating said pausing and resuming steps a predetermined number of times wherein the predetermined number of clocks for pausing and predetermined clocks for resuming may vary on each repetition.

11. The method of Claim 1 wherein said executing step comprises the step of pausing a predetermined number of clock cycles after detecting a predetermined number of occurrences of the specified event and executing the test after pausing.

12. Circuitry for testing a circuit comprising:
at least one event qualification cell (24a) having an internal memory (32) and having compare circuitry (30) for comparing data input into the compare circuitry with data stored in said internal memory (32), operable for detecting each occurrence of a specified event;
circuitry (44) for counting the number of occurrences of the specified event;
circuitry (14) for executing a test responsive to detecting a predetermined number of occurrences of the specified event; and
circuitry (48) for causing said test to be executed for a predetermined number of clock cycles.

13. The circuitry of Claim 12 and further comprising circuitry (48) for repeating said test a predetermined number of times.

14. The circuitry of Claim 12 and further comprising:
circuitry (24b) for detecting a second specified event;
circuitry (44) for counting the number of occurrences of the second specified event; and
circuitry (48) for stopping the test responsive to detection of a predetermined number of occurrences of the second specified event.

15. The circuitry of Claim 14 and further comprising circuitry (48) for repeating said test a predetermined number of times responsive to said counting circuitry and said stopping circuitry.

16. The circuitry of Claim 14 wherein said circuitry (48) for stopping comprises circuitry for stopping the test a predetermined number of clock cycles after a predetermined number of occurrences of the second specified event.

17. The circuitry of Claim 16 and further comprising circuitry (48) for repeating said test a predetermined number of times responsive to said circuitry for counting the number of occurrences of the first event, circuitry (48) for counting the number of occurrences of the second event, and circuitry (48) for stopping the test after detection of a predetermined number of occurrences of the second event.

18. The circuitry of Claim 16 wherein said circuitry (48) for starting the test comprises circuitry for pausing a predetermined number of clock cycles after detecting the predetermined number of occurrences of said first event and circuitry (48) for executing the test after pausing.

19. The circuitry of Claim 18 and further comprising circuitry (48) for repeating the test a predetermined number of times responsive to said circuitry (44) for counting the number of occurrences of the first event, circuitry (48) for pausing, circuitry (48) for executing the test after pausing, circuitry (44) for counting the number of occurrences of the second event, and circuitry (48) for stopping the test after detection of a predetermined number of occurrences of the second event.

20. The circuitry of Claim 12 wherein said executing circuitry (48) further comprises circuitry (48) for pausing for a predetermined number of clocks and resuming the test for a predetermined number of clock cycles.

21. The circuitry of Claim 20 and further comprising circuitry (48) for continuing the test responsive to said circuitry for pausing and circuitry for resuming.

22. The circuitry of Claim 12 wherein said circuitry (48) for executing comprises circuitry (48) for pausing a predetermined number of clock cycles after detecting a predetermined number of occurrences of the specified event and executing the test after pausing.

## Patentansprüche

1. Verfahren zum Testen einer Schaltung, mit den Schritten:
Vorsehen wenigstens einer Ereignisqualifizierungszelle (24a) mit einem internen Speicher (32) und einer Vergleichsschaltungsanordnung (30) zum Vergleichen von in die Vergleichsschaltungsanordnung (30) eingegebenen Daten mit im internen Speicher (32) gespeicherten Daten;
Betreiben der Ereignisqualifizierungszelle (24a) in der Weise, daß sie jedes Auftreten eines vorgegebenen Ereignisses erfaßt;
Zählen der Anzahl von Auftritten des vorgegebenen Ereignisses;
Ausführen eines Tests als Antwort auf die Erfassung einer vorgegebenen Anzahl von Auftritten des vorgegebenen Ereignisses; und
Ausführen des Tests für eine vorgegebene Anzahl von Taktzyklen.

2. Verfahren nach Anspruch 1 und ferner mit dem Schritt des Wiederholens der Zähl- und Ausführungsschritte in einer vorgegebenen Anzahl, wobei die vorgegebene Anzahl von Auftritten des vorgegebenen Ereignisses bei jeder Wiederholung unterschiedlich sein kann.

3. Verfahren nach Anspruch 1 und ferner mit den Schritten:
Erfassen eines zweiten vorgegebenen Ereignisses;
Zählen der Anzahl der Auftritte des zweiten vorgegebenen Ereignisses; und
Anhalten des Tests als Antwort auf die Erfassung einer vorgegebenen Anzahl von Auftritten des zweiten vorgegebenen Ereignisses.

4. Verfahren nach Anspruch 3 und ferner mit dem Schritt des Wiederholens der Schritte des Zählens der Anzahl von Auftritten des ersten vorgegebenen Ereignisses, des Ausführens eines Tests, des Zählens der Anzahl von Auftritten des zweiten vorgegebenen Ereignisses und des Anhaltens des Tests in einer vorgegebenen Anzahl, wobei die vorgegebene Anzahl von Auftritten des ersten vorgegebenen Ereignisses und die vorgegebene Anzahl von Auftritten des zweiten vorgegebenen Ereignisses bei jeder Wiederholung unterschiedlich sein können.

5. Verfahren nach Anspruch 3, in dem der Schritt des Anhaltens des Tests den Schritt des Anhaltens des Tests als Antwort auf die Erfassung einer vorgegebenen Anzahl von Taktzyklen nach einer vorgegebenen Anzahl von Auftritten des zweiten vorgegebenen Ereignisses enthält.

6. Verfahren nach Anspruch 5 und ferner mit dem Schritt des Wiederholens der Schritte des Zählens der Anzahl der Auftritte des ersten Ereignisses, des Ausführens eines Tests als Antwort auf die Erfassung einer vorgegebenen Anzahl von Auftritten des ersten Ereignisses, des Zählens der Anzahl von Auftritten des zweiten Ereignisses sowie des Anhaltens des Tests nach Erfassung einer vorgegebenen Anzahl von Auftritten des zweiten Ereignisses in einer vorgegebenen Anzahl, wobei die vorgegebene Anzahl von Auftritten des ersten vorgegebenen Ereignisses, die vorgegebene Anzahl von Taktzyklen und die vorgegebene Anzahl von Auftritten des zweiten vorgegebenen Ereignisses bei jeder Wiederholung unterschiedlich sein können.

7. Verfahren nach Anspruch 5, in dem der Schritt des Beginnens des Tests die Schritte des Aussetzens für eine vorgegebene Anzahl von Taktzyklen nach der Erfassung der vorgegebenen Anzahl von Auftritten des ersten Ereignisses sowie des Ausführens des Tests nach dem Aussetzen enthält.

8. Verfahren nach Anspruch 7 und ferner mit dem Schritt des Wiederholens der Schritte des Zählens der Anzahl von Auftritten des ersten Ereignisses, des Aussetzens für eine vorgegebene Anzahl von Taktzyklen nach der Erfassung einer vorgegebenen Anzahl von Auftritten des ersten Ereignisses, des Ausführens des Tests nach dem Aussetzen, des Zählens der Anzahl der Auftritte des zweiten Ereignisses und des Anhaltens des Tests nach der Erfassung einer vorgegebenen Anzahl von Auftritten des zweiten Ereignisses in einer vorgegebenen Anzahl, wobei die vorgegebene Anzahl von Auftritten des ersten vorgegebenen Ereignisses, die vorgegebene Anzahl von Auftritten des zweiten vorgegebenen Ereignisses, die vorgegebene Anzahl von Aussetztaktzyklen und die vorgegebene Anzahl von Taktzyklen nach der Erfassung des ersten Ereignisses bei jeder Wiederholung unterschiedlich sein können.

9. Verfahren nach Anspruch 1, in dem der Ausführungsschritt ferner die Schritte des Aussetzens des Tests für eine vorgegebene Anzahl von Takten und des Wiederaufnehmens des Tests für eine vorgegebene Anzahl von Taktzyklen enthält.

10. Verfahren nach Anspruch 9 und ferner mit dem Schritt des Wiederholens der Aussetz- und Wiederaufnahmeschritte in einer vorgegebenen Anzahl, wobei die vorgegebene Anzahl von Takten für das Aussetzen und die vorgegebenen Takte für die Wiederaufnahme bei jeder Wiederholung unterschiedlich sein können.

11. Verfahren nach Anspruch 1, in dem der Ausführungsschritt den Schritt des Aussetzens für eine vorgegebene Anzahl von Taktzyklen nach der Erfassung einer vorgegebenen Anzahl von Auftritten des vorgegebenen Ereignisses und des Ausführens des Tests nach dem Aussetzen enthält.

12. Schaltungsanordnung zum Testen einer Schaltung, mit:
wenigstens einer Ereignisqualifizierungszelle (24a) mit einem internen Speicher (32) und einer Vergleichsschaltungsanordnung (30) zum Vergleichen von in die Vergleichsschaltungsanordnung eingegebenen Daten mit im internen Speicher (32) gespeicherten Daten, die in der Weise betrieben werden kann, daß sie jedes Auftreten eines vorgegebenen Ereignisses erfaßt;
einer Schaltungsanordnung (44) zum Zählen der Anzahl der Auftritte des vorgegebenen Ereignisses;
einer Schaltungsanordnung (14) zum Ausführen eines Tests als Antwort auf die Erfassung einer vorgegebenen Anzahl von Auftritten des vorgegebenen Ereignisses; und
einer Schaltungsanordnung (48), die bewirkt, daß der Test für eine vorgegebene Anzahl von Taktzyklen ausgeführt wird.

13. Schaltungsanordnung nach Anspruch 12, ferner mit einer Schaltungsanordnung (48) zum Wiederholen des Tests in einer vorgegebenen Anzahl.

14. Schaltungsanordnung nach Anspruch 12 und ferner mit:
einer Schaltungsanordnung (24b) zum Erfassen eines zweiten vorgegebenen Ereignisses;
einer Schaltungsanordnung (44) zum Zählen der Anzahl von Auftritten des zweiten vorgegebenen Ereignisses; und
einer Schaltungsanordnung (48) zum Anhalten des Tests als Antwort auf die Erfassung einer vorgegebenen Anzahl von Auftritten des zweiten vorgegebenen Ereignisses.

15. Schaltungsanordnung nach Anspruch 14 und ferner mit einer Schaltungsanordnung (48) zum Wiederholen des Tests in einer vorgegebenen Anzahl als Antwort auf die Zähl-Schaltungsanordnung und die Anhalte-Schaltungsanordnung.

16. Schaltungsanordnung nach Anspruch 14, in der die Anhalte-Schaltungsanordnung (48) eine Schaltungsanordnung zum Anhalten des Tests für eine vorgegebene Anzahl von Taktzyklen nach einer vorgegebenen Anzahl von Auftritten des zweiten vorgegebenen Ereignisses enthält.

17. Schaltungsanordnung nach Anspruch 16 und ferner mit einer Schaltungsanordnung (48), die als Antwort auf die Schaltungsanordnung zum Zählen der Anzahl von Auftritten des ersten Ereignisses, die Schaltungsanordnung (48) zum Zählen der Anzahl der Auftritte des zweiten Ereignisses und die Schaltungsanordnung (48) zum Anhalten des Tests nach Erfassung einer vorgegebenen Anzahl von Auftritten des zweiten Ereignisses den Test in einer vorgegebenen Anzahl wiederholt.

18. Schaltungsanordnung nach Anspruch 16, in der die Schaltungsanordnung (48) zum Beginnen des Tests eine Schaltungsanordnung zum Aussetzen für eine vorgegebene Anzahl von Taktzyklen nach der Erfassung der vorgegebenen Anzahl von Auftritten des ersten Ereignisses sowie eine Schaltungsanordnung (48) zum Ausführen des Tests nach dem Aussetzen enthält.

19. Schaltungsanordnung nach Anspruch 18 und ferner mit einer Schaltungsanordnung (48), die als Antwort auf die Schaltungsanordnung (44) zum Zählen der Anzahl von Auftritten des ersten Ereignisses, die Schaltungsanordnung (48) zum Aussetzen, die Schaltungsanordnung (48) zum Ausführen des Tests nach dem Aussetzen, die Schaltungsanordnung (44) zum Zählen der Anzahl der Auftritte des zweiten Ereignisses und die Schaltungsanordnung (48) zum Anhalten des Tests nach der Erfassung einer vorgegebenen Anzahl von Auftritten des zweiten Ereignisses den Test in einer vorgegebenen Anzahl wiederholt.

20. Schaltungsanordnung nach Anspruch 12, in der die Ausführungsschaltungsanordnung (48) ferner eine Schaltungsanordnung (48) zum Aussetzen für eine vorgegebene Anzahl von Takten und zum Wiederaufnehmen des Tests für eine vorgegebene Anzahl von Taktzyklen enthält.

21. Schaltungsanordnung nach Anspruch 20 und ferner mit einer Schaltungsanordnung (48), die als Antwort auf die Schaltungsanordnung zum Aussetzen und auf die Schaltungsanordnung zum Wiederaufnehmen den Test fortsetzt.

22. Schaltungsanordnung nach Anspruch 12, in der die Ausführungs-Schaltungsanordnung (48) eine Schaltungsanordnung (48) zum Aussetzen für eine vorgegebene Anzahl von Taktzyklen nach der Erfassung einer vorgegebenen Anzahl von Auftritten des vorgegebenen Ereignisses und zum Ausführen des Tests nach dem Ausführen enthält.

## Revendications

1. Procédé pour tester un circuit comprenant les étapes consistant à :
fournir au moins une cellule de qualification d'événement (24a) ayant une mémoire interne (32) et ayant des circuits de comparaison (30) pour comparer des données d'entrée dans les circuits de comparaison (30) avec des données stockées dans ladite mémoire interne (32),
faire fonctionner ladite cellule de qualification d'événement (24a) pour détecter chaque occurrence d'un événement donné,
compter le nombre d'occurrences de l'événement donné,
exécuter un test en réponse à la détection d'un nombre prédéterminé d'occurrences de l'événement donné ; et
exécuter ledit test pour un nombre prédéterminé de cycles d'horloge.

2. Procédé selon la revendication 1, comprenant en outre l'étape consistant à répéter les étapes de comptage et d'exécution un nombre prédéterminé de fois, dans lequel le nombre prédéterminé d'occurrences de l'événement donné peut varier à chaque répétition.

3. Procédé selon la revendication 1, comprenant en outre les étapes consistant à :
détecter un second événement donné,
compter le nombre d'occurrences du second événement donné, et
arrêter le test en réponse à la détection d'un nombre prédéterminé d'occurrences du second événement donné.

4. Procédé selon la revendication 3, comprenant en outre l'étape consistant à répéter un nombre prédéterminé de fois lesdites étapes de comptage du nombre d'occurrences du premier événement donné, d'exécution d'un test, de comptage du nombre d'occurrences du second événement donné et d'arrêt du test, dans lequel le nombre prédéterminé d'occurrences du premier événement donné et le nombre prédéterminé d'occurrences du second événement donné peuvent varier à chaque répétition.

5. Procédé selon la revendication 3, dans lequel ladite étape d'arrêt du test comprend l'étape d'arrêt du test en réponse à la détection d'un nombre prédéterminé de cycles d'horloge après un nombre prédéterminé d'occurrences du second événement donné.

6. Procédé selon la revendication 5, comprenant en outre l'étape consistant à répéter un nombre prédéterminé de fois lesdites étapes de comptage du nombre d'occurrences du premier événement donné, d'exécution d'un test en réponse à la détection d'un nombre prédéterminé d'occurrences du premier événement, de comptage du nombre d'occurrences du second événement, et d'arrêt du test après détection d'un nombre prédéterminé d'occurrences du second événement, dans lequel le nombre prédéterminé d'occurrences du premier événement donné, le nombre prédéterminé de cycles d'horloge et le nombre prédéterminé d'occurrences du second événement donné peuvent varier à chaque répétition.

7. Procédé selon la revendication 5, dans lequel ladite étape consistant à commencer le test comprend les étapes consistant à marquer une pause pendant un nombre prédéterminé de cycles d'horloge après détection du nombre prédéterminé d'occurrences dudit premier événement et à exécuter le test après avoir marqué la pause.

8. Procédé selon la revendication 7, comprenant en outre l'étape consistant à répéter un nombre prédéterminé de fois lesdites étapes de comptage du nombre d'occurrences du premier événement, de pause pendant un nombre prédéterminé de cycles d'horloge après détection du nombre prédéterminé d'occurrences du premier événement, d'exécution du test après avoir marqué la pause, de comptage du nombre d'occurrences du second événement, et d'arrêt du test après détection d'un nombre prédéterminé d'occurrences du second événement ,dans lequel le nombre prédéterminé d'occurrences du premier événement donné, le nombre prédéterminé d'occurrences du second événement donné, le nombre prédéterminé de cycles d'horloge de pause, le nombre prédéterminé de cycles d'horloge après détection dudit premier événement peuvent varier à chaque répétition.

9. Procédé selon la revendication 1, dans lequel ladite étape d'exécution comprend en outre l'étape consistant à marquer une pause lors du test pendant un nombre prédéterminé de cycles d'horloge et reprendre le test pour un nombre prédéterminé de cycles d'horloge.

10. Procédé selon la revendication 9, comprenant en outre l'étape consistant à répéter lesdites étapes de pause et de reprise un nombre prédéterminé de fois, dans lequel le nombre prédéterminé de cycles d'horloge pour marquer la pause, le nombre prédéterminé de cycles d'horloge de reprise peuvent varier à chaque répétition.

11. Procédé selon la revendication 1, dans lequel ladite étape d'exécution comprend l'étape consistant à marquer une pause pendant un nombre prédéterminé de cycles d'horloge après détection d'un nombre prédéterminé d'occurrences de l'événement donné et à exécuter le test après avoir marqué la pause.

12. Circuits pour tester un circuit comprenant :
au moins une cellule de qualification d'événement (24a),
ayant une mémoire interne (32) et ayant des circuits de comparaison (30) pour comparer des données d'entrée dans les circuits de comparaison avec des données stockées dans ladite mémoire interne (32), utilisable pour détecter chaque occurrence d'un événement donné, des circuits (44) pour compter le nombre d'occurrences de l'événement donné, des circuits (14) pour exécuter un test en réponse à la détection d'un nombre prédéterminé d'occurrences de l'événement donné, et des circuits (48) pour provoquer l'exécution dudit test pour un nombre prédéterminé de cycles d'horloge.

13. Circuits selon la revendication 12, comprenant en outre des circuits (48) pour répéter ledit test un nombre prédéterminé de fois.

14. Circuits selon la revendication 12, comprenant en outre des circuits (24b) pour détecter un second événement donné,
des circuits (44) pour compter le nombre d'occurrences du second événement donné, et
des circuits (48) pour arrêter le test en réponse à la détection d'un nombre prédéterminé d'occurrences du second événement donné.

15. Circuits selon la revendication 14, comprenant en outre des circuits (48) pour répéter ledit test un nombre prédéterminé de fois en réponse auxdits circuits de comptage et auxdits circuits d'arrêt.

16. Circuits selon la revendication 14, dans lesquels lesdits circuits (48) pour arrêter comprennent des circuits pour arrêter le test un nombre prédéterminé de cycles d'horloge après un nombre prédéterminé d'occurrences dudit second événement donné.

17. Circuits selon la revendication 16, comprenant en outre des circuits (48) pour répéter ledit test un nombre prédéterminé de fois en réponse auxdits circuits pour compter le nombre d'occurrences du premier événement, des circuits (48) pour compter le nombre d'occurrences du second événement, et des circuits (48) pour arrêter le test après détection d'un nombre prédéterminé d'occurrences du second événement.

18. Circuits selon la revendication 16, dans lesquels lesdits circuits (48) pour démarrer le test comprennent des circuits pour marquer une pause pendant un nombre prédéterminé de cycles d'horloge après détection d'un nombre prédéterminé d'occurrences dudit premier événement et des circuits (48) pour exécuter le test après avoir marqué la pause.

19. Circuits selon la revendication 18, comprenant en outre des circuits (48) pour répéter ledit test un nombre prédéterminé de fois en réponse auxdits circuits (44) pour compter le nombre d'occurrences du premier événement, des circuits (48) pour marquer une pause, des circuits (48) pour exécuter le test après la pause, des circuits (44) pour compter le nombre d'occurrences du second événement et des circuits (48) pour arrêter le test après détection d'un nombre prédéterminé d'occurrences du second événement.

20. Circuits selon la revendication 12, dans lesquels lesdits circuits d'exécution (48) comprennent en outre des circuits (48) pour marquer une pause pendant un nombre prédéterminé de cycles d'horloge et reprendre le test pendant un nombre prédéterminé de cycles d'horloge.

21. Circuits selon la revendication 20, comprenant en outre des circuits (48) pour continuer le test en réponse auxdits circuits pour marquer une pause et lesdits circuits de reprise.

22. Circuits selon la revendication 12, dans lesquels lesdits circuits (48) pour exécuter (**?**) comprennent des circuits (48) pour marquer une pause pendant un nombre prédéterminé de cycles d'horloge après détection d'un nombre prédéterminé d'occurrences de l'événement donné et exécuter le test après avoir marqué la pause.
